# EUROPEAN PATENT APPLICATION

(11) **EP 4 648 587 A1**
(43) Date of publication of application: **12.11.2025**
(21) Application number: 24806289.5
(22) Date of filing: 19.04.2024
(51) Int. Cl.: H10K 59/121

(54) **DISPLAY SUBSTRATE, PREPARATION METHOD THEREFOR, AND DISPLAY APPARATUS**

(30) Priority: 17.05.2023 CN 202310558568
(71) Applicant: Boe Technology Group Co., Ltd., Beijing 100015 (CN); Chengdu BOE Optoelectronics Technology Co., Ltd., Chengdu, Sichuan 611731 (CN); Beijing BOE Technology Development Co., Ltd., Beijing 100176 (CN)
(72) Inventor: HAN, Tao, Beijing 100176 (CN); YAN, Jun, Beijing 100176 (CN); LIU, Tingliang, Beijing 100176 (CN); LIU, Zhen, Beijing 100176 (CN); TONG, Kemeng, Beijing 100176 (CN); HE, Yi, Beijing 100176 (CN)
(74) Representative: Durán-Corretjer, S.L.P.
(86) International application number: PCT/CN2024/088791
(87) International publication number: WO 2024/234932

(57) **Abstract**

A display substrate, a preparation method therefor, and a display apparatus. The display substrate comprises a drive circuit layer arranged on a base, the drive circuit layer comprising a plurality of circuit units, at least one scan signal line, and at least one data signal line; at least one circuit unit comprises a pixel drive circuit, the pixel drive circuit at least comprises a plurality of oxide transistors, and at least one oxide transistor is respectively connected to a scan signal line and a data signal line; in a direction perpendicular to the base, the drive circuit layer at least comprises, successively arranged in a direction away from the base, a first source/drain metal layer and a second source/drain metal layer, the first source/drain metal layer at least comprising a scan signal line, and the second source/drain metal layer at least comprising a data signal line. By arranging a scan signal line on the first source/drain metal layer, the present disclosure effectively reduces the electrical resistance of the scan signal line, thereby reducing a scan signal voltage drop, effectively increasing compensation speed, and improving display quality.

## Description

The present application claims priority to Chinese Patent Application No. 202310558568.4 filed to the CNIPA on May 17, 2023 and entitled "Display Substrate, Preparation Method Therefor, and Display Apparatus", contents of which should be construed as being incorporated into the present application by reference.

### Technical Field

The present disclosure relates to, but is not limited to, the field of display technologies, and particularly to a display substrate and a preparation method therefor, and a display apparatus.

### Background

An Organic Light Emitting Diode (OLED) and a Quantum dot Light Emitting Diode (QLED) are active light emitting display devices and have advantages of self-illumination, a wide viewing angle, a high contrast ratio, low power consumption, an extremely high reaction speed, lightness and thinness, flexibility, and a low cost, etc. With constant development of display technologies, a flexible display apparatus (Flexible Display) in which an OLED or a QLED is used as a light emitting device and signal control is performed through a Thin Film Transistor (TFT for short) has become a mainstream product in the field of display at present.

### Summary

The following is a summary of subject matters described herein in detail. This summary is not intended to limit the protection scope of claims.

In one aspect, the present disclosure provides a display substrate including a drive circuit layer disposed on a base substrate. The drive circuit layer includes a plurality of circuit units, at least one scan signal line extending in a first direction, and at least one data signal line extending in a second direction, and the first direction is intersected with the second direction. At least one circuit unit includes a pixel drive circuit, and the pixel drive circuit includes at least a plurality of oxide transistors. At least one oxide transistor is connected to the scan signal line and the data signal line, respectively. In a direction perpendicular to the base substrate, the drive circuit layer includes at least a first source-drain metal layer and a second source-drain metal layer that are sequentially disposed along a direction away from the base substrate. The first source-drain metal layer includes at least the scan signal line, and the second source-drain metal layer includes at least the data signal line.

In an exemplary implementation, the drive circuit layer further includes a first conductive layer and a second conductive layer that are sequentially disposed along a direction away from the base substrate. The first source-drain metal layer is disposed on a side of the second conductive layer away from the base substrate. At least one oxide transistor includes at least a bottom gate electrode disposed in the first conductive layer and a top gate electrode disposed in the second conductive layer. The scan signal line is respectively connected to the bottom gate electrode and the top gate electrode through a via.

In an exemplary implementation, the pixel drive circuit further includes a storage capacitor, and the storage capacitor includes a first sub-capacitor and a second sub-capacitor. The first sub-capacitor includes a first plate and a second plate, and an orthographic projection of the first plate on the base substrate is at least partially overlapped with an orthographic projection of the second plate on the base substrate. The second sub-capacitor includes the second plate and a third plate, and the orthographic projection of the second plate on the base substrate is at least partially overlapped with an orthographic projection of the third plate on the base substrate. The first plate is connected to the third plate.

In an exemplary implementation, the drive circuit layer further includes a shielding conductive layer, a first conductive layer, and a second conductive layer that are sequentially disposed along the direction away from the base substrate. The first source-drain metal layer is disposed on a side of the second conductive layer away from the base substrate. The first plate is disposed in the shielding conductive layer, the second plate is disposed in the first conductive layer, and the third plate is disposed in the second conductive layer. The third plate is connected to the first plate through a connection electrode.

In an exemplary implementation, the connection electrode is disposed in the first source-drain metal layer, a first terminal of the connection electrode is connected to the first plate through a via, and a second terminal of the connection electrode is connected to the third plate through a via.

In an exemplary implementation, the plurality of oxide transistors includes a first transistor, a second transistor, a third transistor, a fourth transistor, a fifth transistor, and a sixth transistor. A first electrode of the first transistor is connected to an initial signal line. A second electrode of the first transistor is respectively connected to a second electrode of the sixth transistor and a second plate of a storage capacitor. A first electrode of the second transistor is respectively connected to a gate electrode of the third transistor and a first plate of the storage capacitor. A second electrode of the second transistor is respectively connected to a first electrode of the third transistor and a second electrode of the fifth transistor. A second electrode of the third transistor is respectively connected to a second electrode of the fourth transistor and a first electrode of the sixth transistor. A first electrode of the fourth transistor is connected to the data signal line. A first electrode of the fifth transistor is connected to a first power supply line. The fourth transistor and the fifth transistor are disposed on a side of the third transistor in the second direction. The first transistor, the second transistor, and the sixth transistor are disposed on another side of the third transistor in the second direction.

In an exemplary implementation, the first transistor includes at least a first bottom gate electrode and a first top gate electrode, and the second transistor includes at least a second bottom gate electrode and a second top gate electrode. The first bottom gate electrode and the second bottom gate electrode are of an interconnected integral structure, and the first top gate electrode and the second top gate electrode are of an interconnected integral structure.

In an exemplary implementation, the drive circuit layer further includes at least one first power supply connection line extending in the first direction, and at least one first power supply line extending in the second direction. The first power supply line is connected to the first power supply connection line to form a net-like structure for transmitting a first power supply signal.

In an exemplary implementation, the display substrate further includes a light emitting structure layer disposed on a side of the drive circuit layer away from the base substrate. The light emitting structure layer includes a plurality of light emitting units. At least one light emitting unit includes an anode. At least one anode is uniformly distributed with respect to the first power supply line.

In an exemplary implementation, the plurality of circuit units includes a first circuit unit, a second circuit unit, and a third circuit unit that are sequentially disposed along the first direction. At least one anode includes an anode main body portion, a first compensation portion, and a second compensation portion. An orthographic projection of the first compensation portion on the base substrate is at least partially overlapped with an orthographic projection of a first power supply line of the first circuit unit on the base substrate. An orthographic projection of the anode main body portion on the base substrate is at least partially overlapped with an orthographic projection of a first power supply line of the second circuit unit on the base substrate. An orthographic projection of the second compensation portion on the base substrate is at least partially overlapped with an orthographic projection of a first power supply line of the third circuit unit on the base substrate.

In an exemplary implementation, the plurality of light emitting units include a first light emitting unit, a second light emitting unit, and a third light emitting unit that are arranged in a triangle. An orthographic projection of an anode of the first light emitting unit on the base substrate is at least partially overlapped with orthographic projections of first power supply lines of the first circuit unit, the second circuit unit and the third circuit unit on the base substrate. An orthographic projection of an anode of the second light emitting unit on the base substrate is at least partially overlapped with the orthographic projection of the first power supply line of the second circuit unit on the base substrate. An orthographic projection of an anode of the third light emitting unit on the base substrate is at least partially overlapped with the orthographic projection of the first power supply line of the third circuit unit on the base substrate.

In an exemplary implementation, the drive circuit layer further includes at least one second power supply connection line extending in the first direction, and at least one second power supply line extending in the second direction. The second power supply line is connected to the second power supply connection line to form a net-like structure for transmitting a second power supply signal.

In an exemplary implementation, the drive circuit layer further includes at least one initial signal line extending in the first direction, and at least one initial connection line extending in the second direction. The initial signal line is connected to the initial connection line to form a net-like structure for transmitting an initial signal.

In another aspect, a display apparatus is also provided in the present disclosure, and the display apparatus includes the display substrate described above.

In another aspect, the present disclosure further provides a preparation method for a display substrate, including: forming a drive circuit layer on a base substrate, herein the drive circuit layer includes a plurality of circuit units, at least one scan signal line extending in a first direction, and at least one data signal line extending in a second direction. The first direction is intersected with the second direction. At least one circuit unit includes a pixel drive circuit, and the pixel drive circuit includes at least a plurality of oxide transistors. At least one oxide transistor is respectively connected to the scan signal line and the data signal line. In a direction perpendicular to the base substrate, the drive circuit layer includes at least a first source-drain metal layer and a second source-drain metal layer that are sequentially disposed along a direction away from the base substrate. The first source-drain metal layer includes at least the scan signal line, and the second source-drain metal layer includes at least the data signal line.

Other aspects of the present disclosure may be comprehended after the drawings and the detailed descriptions are read and understood.

### Brief Description of Drawings

Accompanying drawings are used to provide understanding of technical solutions of the present disclosure, and form a part of the specification. The accompanying drawings and embodiments of the present disclosure are adopted to explain the technical solutions of the present disclosure, but do not form limitations on the technical solutions of the present disclosure.
FIG. 1 is a schematic diagram of a structure of a display apparatus.
FIG. 2 is a schematic diagram of a planar structure of a display substrate.
FIG.3 is a schematic diagram of a sectional structure of a display substrate.
FIG.4 is an equivalent circuit diagram of a pixel drive circuit according to an exemplary embodiment of the present disclosure.
FIG.5 is a schematic diagram of a planar structure of a display substrate according to an exemplary embodiment of the present disclosure.
FIG. 6 is a schematic diagram of structures of a storage capacitor and a fourth transistor in FIG. 5.
FIG. 7 is a schematic diagram after a pattern of a shielding conductive layer is formed according to an embodiment of the present disclosure.
FIGS. 8A and 8B are schematic diagrams after a pattern of a first conductive layer is formed according to an embodiment of the present disclosure.
FIGS. 9A and 9B are schematic diagrams after a pattern of a semiconductor layer is formed according to an embodiment of the present disclosure.
FIGS. 10A and 10B are schematic diagrams after a pattern of a second conductive layer is formed according to an embodiment of the present disclosure.
FIG. 11 is a schematic diagram after a pattern of a fourth insulation layer is formed according to an embodiment of the present disclosure.
FIGS. 12A and 12B are schematic diagrams after a pattern of a third conductive layer is formed according to an embodiment of the present disclosure.
FIG. 13 is a schematic diagram after a pattern of a first planarization layer is formed according to an embodiment of the present disclosure.
FIGS. 14A and 14B are schematic diagrams after a pattern of a fourth conductive layer is formed according to an embodiment of the present disclosure.
FIG. 15 is a schematic diagram after a pattern of a second planarization layer is formed according to an embodiment of the present disclosure.
FIGS. 16A and 16B are schematic diagrams after a pattern of an anode conductive layer is formed according to an embodiment of the present disclosure.
FIG. 17 is a schematic diagram after a pattern of a pixel definition layer is formed according to an embodiment of the present disclosure.

Reference signs are described as follows.

| | | |
|---|---|---|
| 10-First plate; | 11-First plate electrode; | 20-Second plate; |
| 21-First bottom gate electrode; | 22-Second bottom gate electrode; | 24-Fourth bottom gate electrode; |
| 25-Fifth bottom gate electrode; | 26-Sixth bottom gate electrode; | 27-Second plate electrode; |
| 30-Third plate; | 31-First active layer; | 32-Second active layer; |
| 33-Third active layer; | 34-Fourth active layer; | 35-Fifth active layer; |
| 36-Sixth active layer; | 41-First top gate electrode; | 42-Second top gate electrode; |
| 44-Fourth top gate electrode; | 45-Fifth top gate electrode; | 46-Sixth bottom top gate electrode; |
| 47-Third plate electrode; | 51-First connection electrode; | 52-Second connection electrode; |
| 53-Third connection electrode; | 54-Fourth connection electrode; | 55-Fifth connection electrode; |
| 61-First scan signal line; | 62-Second scan signal line; | 63-First light emitting signal line; |
| 64-line; Second light emitting signal | 65-Initial signal line; | 66-First power supply connection line; |
| 67-Second power supply connection line; | 71-First power supply line; | 72-Second power supply line; |
| 73-Data signal line; | 74-Initial connection line; | 75-Anode connection electrode; |
| 81-First anode; | 82-Second anode; | 83-Third anode; |
| 101-Base substrate; | 102-Drive circuit layer; | 103-Light emitting structure layer; |
| 104-layer. Encapsulation structure | | |

### Detailed Description

To make objectives, technical solutions, and advantages of the present disclosure clearer, the embodiments of the present disclosure will be described in detail below with reference to the accompanying drawings. It is to be noted that implementations may be implemented in multiple different forms. Those of ordinary skills in the art may easily understand such a fact that modes and contents may be transformed into various forms without departing from the purpose and scope of the present disclosure. Therefore, the present disclosure should not be explained as being limited to the contents recorded in the following implementations only. The embodiments and features in the embodiments of the present disclosure may be randomly combined with each other if there is no conflict.

Scales of the drawings in the present disclosure may be used as a reference in actual processes, but are not limited thereto. For example, a width-length ratio of a channel, a thickness and spacing of each film layer, and a width and spacing of each signal line may be adjusted according to actual needs. A quantity of pixels in a display substrate and a quantity of sub-pixels in each pixel are not limited to numbers shown in the drawings. The drawings described in the present disclosure are schematic structural diagrams only, and one mode of the present disclosure is not limited to shapes, numerical values, or the like shown in the drawings.

Ordinal numerals "first", "second", "third", etc., in the specification are set not to form limits in numbers but only to avoid confusion between constituent elements.

In the specification, for convenience, expressions "central", "above", "below", "front", "back", "vertical", "horizontal", "top", "bottom", "inside", "outside", etc., for indicating directional or positional relationships are used to illustrate positional relationships between the constituent elements with reference to the accompanying drawings, not to indicate or imply that involved devices or elements are required to have specific orientations or are structured and operated in the specific orientations but only to easily describe the present specification and simplify the description, and thus should not be understood as limitations on the present disclosure. The positional relationships between the constituent elements may be changed as appropriate based on a direction according to which each constituent element is described. Therefore, appropriate replacements based on situations are allowed, which is not limited to the expressions in the specification.

In the specification, unless otherwise explicitly specified and defined, terms "mounting", "coupling", and "connection" should be understood in a broad sense. For example, it may be a fixed connection, or a detachable connection, or an integral connection; it may be a mechanical connection or an electrical connection; it may be a direct connection, or an indirect connection through a middleware, or an internal communication between two elements. Those of ordinary skills in the art may understand specific meanings of the above terms in the present disclosure according to specific situations.

In the specification, a transistor refers to an element that at least includes three terminals, i.e., a gate electrode, a drain electrode, and a source electrode. The transistor has a channel region between the drain electrode (drain electrode terminal, drain region, or drain electrode) and the source electrode (source electrode terminal, source region, or source electrode), and a current can flow through the drain electrode, the channel region, and the source electrode. It is to be noted that in the specification, the channel region refers to a region through which a current mainly flows.

In the specification, a first electrode may be a drain electrode, and a second electrode may be a source electrode. Or, the first electrode may be a source electrode, and the second electrode may be a drain electrode. In a case that transistors with opposite polarities are used, or in a case that a direction of a current changes during operation of a circuit, or the like, functions of the "source electrode" and the "drain electrode" are sometimes interchangeable. Therefore, the "source electrode" and the "drain electrode", as well as a "source terminal" and a "drain terminal", are interchangeable in the specification.

In the specification, an "electrical connection" includes a case that constituent elements are connected together through an element with a certain electrical action. The "element with a certain electrical action" is not particularly limited as long as electrical signals between the connected constituent elements may be sent and received. Examples of the "element with a certain electrical action" not only include an electrode and a wiring, but also include a switching element such as a transistor, a resistor, an inductor, a capacitor, another element with various functions, etc.

In the specification, "parallel" refers to a state in which an angle formed by two straight lines is above -10° and below 10°, and thus also includes a state in which the angle is above -5° and below 5°. In addition, "perpendicular" refers to a state in which an angle formed by two straight lines is above 80° and below 100°, and thus also includes a state in which the angle is above 85° and below 95°.

In the specification, a "film" and a "layer" are interchangeable. For example, a "conductive layer" may be replaced with a "conductive film" sometimes. Similarly, an "insulation film" may be replaced with an "insulation layer" sometimes.

A triangle, rectangle, trapezoid, pentagon, or hexagon, etc. in the specification is not strictly defined, and it may be an approximate triangle, rectangle, trapezoid, pentagon, or hexagon, etc. There may be some small deformations caused by tolerance, and there may be a chamfer, an arc edge, deformation, etc. In the present disclosure, "about" means that a boundary is not defined so strictly and numerical values within process and measurement error ranges are allowed.

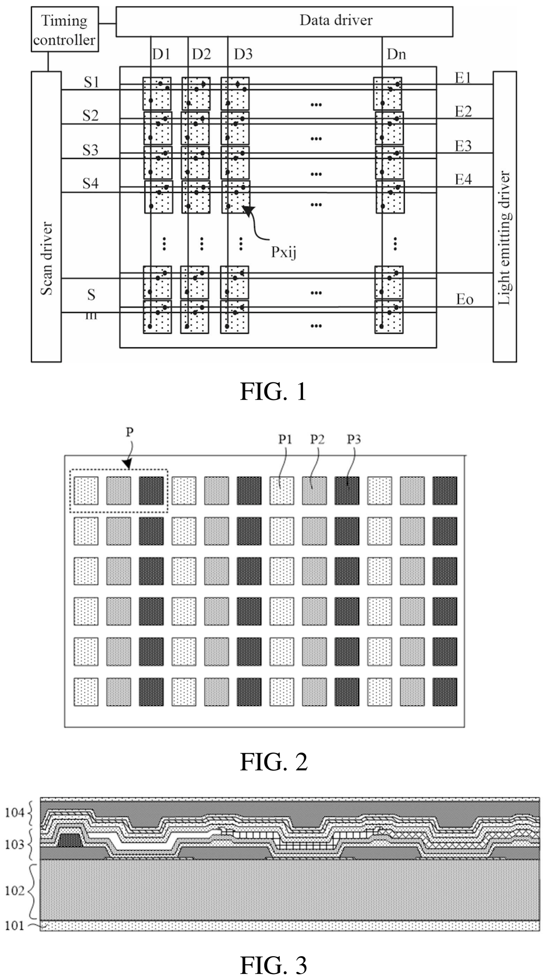

FIG. 1 is a schematic diagram of a structure of a display apparatus. As shown in FIG.1, the display apparatus may include a timing controller, a data driver, a scan driver, a light emitting driver, and a pixel array. The timing controller is connected to the data driver, the scan driver, and the light emitting driver, respectively, the data driver is connected to a plurality of data signal lines (D1 to Dn) respectively, the scan driver is connected to a plurality of scan signal lines (S1 to Sm) respectively, and the light emitting driver is connected to a plurality of light emitting signal lines (E1 to Eo) respectively. The pixel array may include multiple sub-pixels Pxij, where i and j may be natural numbers. At least one sub-pixel Pxij may include a circuit unit and a light emitting device connected to the circuit unit, and the circuit unit may include a pixel drive circuit which is connected with a scan signal line, a light emitting signal line and a data signal line. In an exemplary implementation mode, the timing controller may provide the data driver with a grayscale value and a control signal which are suitable for a specification of the data driver, provide the scan driver with a clock signal and a scan start signal and the like which are suitable for a specification of the scan driver, and provide the light emitting driver with a clock signal and an emission stop signal and the like which are suitable for a specification of the light emitting driver. The data driver may generate data voltages to be provided to the data signal lines D1, D2, D3, ..., and Dn using the grayscale value and the control signal that are received from the timing controller. For example, the data driver may sample the grayscale value by using the clock signal and apply a data voltage corresponding to the grayscale value to the data signal lines D1 to Dn by taking a unit row as a unit, where n may be a natural number. The scan driver may generate a scan signals to be provided to the scan signal lines S1, S2, S3, ..., and Sm by receiving the clock signal and the scan start signal from the timing controller. For example, the scan driver may sequentially provide a scan signal with an on-level pulse to the scan signal lines S1 to Sm. For example, the scan driver may be constructed in a form of a shift register and may generate a scan signal in a manner in which a scan start signal provided in a form of an on-level pulse is transmitted to a next-stage circuit sequentially under control of the clock signal, where m may be a natural number. The light emitting driver may receive a clock signal, an emission stop signal, etc., from the timing controller to generate an emission signal to be provided to the light emitting signal lines E1, E2, E3, ..., and Eo. For example, the light emitting driver may sequentially provide an emission signal with an off-level pulse to the light emitting signal lines E1 to Eo. For example, the light emitting driver may be constructed in a form of a shift register and generate an emission signal in a manner of sequentially transmitting an emission stop signal provided in a form of an off-level pulse to a next-stage circuit under control of the clock signal, where o may be a natural number. In an exemplary implementation, the pixel array may be arranged on a display substrate.

FIG.2 is a schematic diagram of a planar structure of a display substrate. As shown in FIG. 2, the display substrate may include a plurality of pixel units P arranged in a matrix. At least one pixel unit P may include a first sub-pixel P1 emitting light of a first color, a second sub-pixel P2 emitting light of a second color, and a third sub-pixel P3 emitting light of a third color. Each sub-pixel may include a circuit unit and a light emitting device. The circuit unit may at least include a pixel drive circuit, the pixel drive circuit is connected to a scan signal line, a light emitting signal line, and a data signal line respectively, and the pixel drive circuit is configured to receive a data voltage transmitted by the data signal line and output a corresponding current to the light emitting device under control of the scan signal line and the light emitting signal line. The light emitting device in each sub-pixel is connected to a pixel drive circuit of a sub-pixel where the light emitting device is located, and is configured to emit light with corresponding brightness in response to a current output by the pixel drive circuit of the sub-pixel where the light emitting device is located.

In an exemplary implementation, the first sub-pixel P1 may be a red (R) sub-pixel emitting red light, the second sub-pixel P2 may be a blue (B) sub-pixel emitting blue light, and the third sub-pixel P3 may be a green (G) sub-pixel emitting green light. In an exemplary implementation, a sub-pixel may be in a shape of a rectangle, a rhombus, a pentagon, or a hexagon. Three sub-pixels may be arranged in a manner to stand side by side horizontally, in a manner to stand side by side vertically, or in a delta-shaped arrangement, etc., which is not limited here in the present disclosure.

In an exemplary implementation, a pixel unit may include four sub-pixels, and the four sub-pixels may be arranged in a manner to stand side by side horizontally, in a manner to stand side by side vertically, or in a manner of forming a square, which is not limited here in the present disclosure.

FIG. 3 is a schematic diagram of a sectional structure of a display substrate, which illustrates a structure of three sub-pixels. As shown in FIG.3, on a plane perpendicular to the display substrate, the display substrate may include a drive circuit layer 102 arranged on a base substrate 101, a light emitting structure layer 103 arranged on a side of the drive circuit layer 102 away from the base substrate 101, and an encapsulation structure layer 104 arranged on a side of the light emitting structure layer 103 away from the base substrate 101. In some possible implementations, the display substrate may include another film layer, such as a touch structure layer, which is not limited here in the present disclosure.

In an exemplary implementation, on a plane parallel to the display substrate, the drive circuit layer 102 may include a plurality of circuit units, each of which may include a pixel drive circuit, and a scan signal line, a light emitting signal line, a data signal line, a first power supply line, etc., connected to the pixel drive circuit, and the pixel drive circuit may include at least a plurality of transistors and a storage capacitor. The light emitting structure layer 103 may include a plurality of light emitting devices, and each light emitting device may at least include an anode, an organic light emitting layer, and a cathode. The anode is connected with a pixel drive circuit. The organic light emitting layer is connected with the anode. The cathode is connected with the organic light emitting layer. The organic light emitting layer emits light of a corresponding color under drive of the anode and the cathode. The encapsulation structure layer 104 may include a first encapsulation structure layer, a second encapsulation structure layer, and a third encapsulation structure layer that are stacked. The first encapsulation structure layer and the third encapsulation structure layer may be made of an inorganic material, the second encapsulation structure layer may be made of an organic material, and the second encapsulation structure layer is arranged between the first encapsulation structure layer and the third encapsulation structure layer to form a laminated structure of inorganic material/organic material/inorganic material, ensuring that external moisture cannot enter the light emitting structure layer 103.

In an exemplary implementation, the organic light emitting layer may include an Emitting Layer (EML), and any one or more of following layers: a Hole Injection Layer (HIL), a Hole Transport Layer (HTL), an Electron Block Layer (EBL), a Hole Block Layer (HBL), an Electron Transport Layer (ETL), and an Electron Injection Layer (EIL). In an exemplary implementation, one or more of hole injection layers, hole transport layers, electron block layers, hole block layers, electron transport layers, and electron injection layers of all sub-pixels may be a common layer communicated together. Emitting layers of adjacent circuit units may be overlapped slightly, or may be mutually isolated.

With gradual maturity of an OLED display technology and continuous improvement of a yield, a cost of an OLED display apparatus is continuously decreasing, which enables the OLED display apparatus to be gradually applied in more fields, e.g., a field of large and medium-sized electronic products. With an increase in size of the display substrate, the yield of the display substrate using Low Temperature Poly-Silicon (LTPS) thin film transistors decreases, resulting in a relatively high cost. Therefore, display substrates entirely using oxide transistors become to be valued. Through research, it has been found that existing display substrates have problems such as poor display.

An exemplary embodiment of the present disclosure provides a display substrate including a drive circuit layer disposed on a base substrate. The drive circuit layer includes a plurality of circuit units, at least one scan signal line extending in a first direction, and at least one data signal line extending in a second direction, and the first direction is intersected with the second direction. At least one circuit unit includes a pixel drive circuit, and the pixel drive circuit includes at least a plurality of oxide transistors. At least one oxide transistor is connected to the scan signal line and the data signal line, respectively. In a direction perpendicular to the base substrate, the drive circuit layer includes at least a first source-drain metal layer and a second source-drain metal layer that are sequentially disposed along a direction away from the base substrate. The first source-drain metal layer includes at least the scan signal line, and the second source-drain metal layer includes at least the data signal line.

In an exemplary implementation, the drive circuit layer further includes a first conductive layer and a second conductive layer that are sequentially disposed along a direction away from the base substrate. The first source-drain metal layer is disposed on a side of the second conductive layer away from the base substrate. At least one oxide transistor includes a bottom gate electrode disposed in the first conductive layer and a top gate electrode disposed in the second conductive layer. The scan signal line is respectively connected to the bottom gate electrode and the top gate electrode through a via.

In an exemplary implementation, the plurality of oxide transistors includes a first transistor, a second transistor, a third transistor, a fourth transistor, a fifth transistor, and a sixth transistor. A first electrode of the first transistor is connected to an initial signal line. A first electrode of the fourth transistor is connected to a data signal line. A first electrode of the fifth transistor is connected to a first power supply line. A second electrode of the first transistor is connected to a second electrode of the sixth transistor and a second plate of a storage capacitor, respectively. A first electrode of the second transistor is connected to a gate electrode of the third transistor and a first plate of the storage capacitor, respectively. A second electrode of the second transistor is connected to a first electrode of the third transistor and a second electrode of the fifth transistor, respectively. A second electrode of the third transistor is connected to a second electrode of the fourth transistor and a first electrode of the sixth transistor, respectively. The fourth transistor and the fifth transistor are disposed on a side of the third transistor in the second direction. The first transistor, the second transistor, and the sixth transistor are disposed on the other side of the third transistor in the second direction.

In an exemplary implementation, the first transistor includes at least a first bottom gate electrode and a first top gate electrode, and the second transistor includes at least a second bottom gate electrode and a second top gate electrode. The first bottom gate electrode and the second bottom gate electrode are of an interconnected integral structure, and the first top gate electrode and the second top gate electrode are of an interconnected integral structure.

In an exemplary implementation, the drive circuit layer further includes at least one first power supply connection line extending in the first direction, and at least one first power supply line extending in the second direction. The first power supply line is connected to the first power supply connection line to form a net-like structure for transmitting a first power supply signal.

In an exemplary implementation, the drive circuit layer further includes at least one second power supply connection line extending in the first direction, and at least one second power supply line extending in the second direction. The second power supply line is connected to the second power supply connection line to form a net-like structure for transmitting a second power supply signal.

In an exemplary implementation, the drive circuit layer further includes at least one initial signal line extending in the first direction, and at least one initial connection line extending in the second direction. The initial signal line is connected to the initial connection line to form a net-like structure for transmitting an initial signal.

The display substrate of the present embodiment will now be described through some examples.

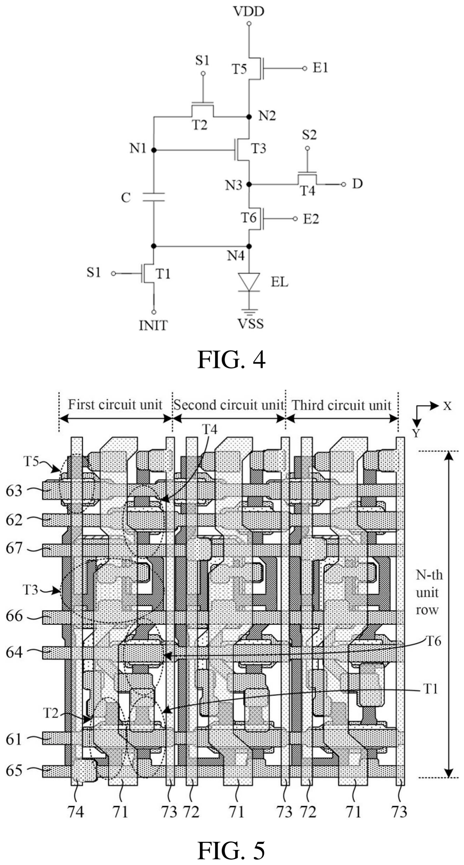

FIG.4 is an equivalent circuit diagram of a pixel drive circuit according to an exemplary embodiment of the present disclosure. As shown in FIG.4, in an exemplary implementation, the pixel drive circuit according to an exemplary embodiment of the present disclosure adopts a 6T1C structure, in which the pixel drive circuit may include six transistors (a first transistor T1 to a sixth transistor T6) and one storage capacitor C, and the pixel drive circuit is respectively connected to seven signal lines (a first scan signal line S1, a second scan signal line S2, a first light emitting signal line E1, a second light emitting signal line E2, an initial signal line INIT, a data signal line D and a first power supply line VDD).

In an exemplary implementation, the pixel drive circuit may include a first node N1, a second node N2, a third node N3, and a fourth node N4. The first node N1 is connected to a first electrode of the second transistor T2, a gate electrode of the third transistor T3 and a first plate of the storage capacitor C, respectively. The second node N2 is connected to a second electrode of the second transistor T2, a first electrode of the third transistor T3 and a second electrode of the fifth transistor T5, respectively. The third node N3 is connected to a second electrode of the third transistor T3, a second electrode of the fourth transistor T4 and a first electrode of the sixth transistor T6, respectively. The fourth node N4 is connected to a second electrode of the first transistor T1, a second electrode of the sixth transistor T6 and a second plate of the storage capacitor C, respectively.

In an exemplary implementation, the first plate of the storage capacitor C is connected to the first node N1, and the second plate of the storage capacitor C is connected to the fourth node N4.

In an exemplary implementation, the gate electrode of the first transistor T1 is connected to the first scan signal line S1, the first electrode of the first transistor T1 is connected to the initial signal line INIT, and the second electrode of the first transistor T1 is connected to the fourth node N4. When an on-level scan signal is applied to the first scan signal line S1, the first transistor T1 is turned on to transmit an initialization voltage to the fourth node N4 respectively to initialize the storage capacitor C and a light emitting device EL.

In an exemplary implementation, a gate electrode of the second transistor T2 is connected to the first scan signal line S1, a first electrode of the second transistor T2 is connected to the first node N1, and a second electrode of the second transistor T2 is connected to the second node N2. When an on-level scan signal is applied to the first scan signal line S1, the second transistor T2 connects the first node N1 with the second node N2.

In an exemplary implementation, the gate electrode of the third transistor T3 is connected to the first node N1, the first electrode of the third transistor T3 is connected to the second node N2, and the second electrode of the third transistor T3 is connected to the third node N3. The third transistor T3 may be referred to as a drive transistor, and the third transistor T3 determines a magnitude of a drive current flowing between the first power supply line VDD and the light emitting device according to a potential difference between the gate electrode and the first electrode of the third transistor T3.

In an exemplary implementation, a gate electrode of the fourth transistor T4 is connected to the second scan signal line S2, a first electrode of the fourth transistor T4 is connected to the data signal line D, and a second electrode of the fourth transistor T4 is connected to the third node N3. When an on-level scan signal is applied to the second scan signal line S2, the fourth transistor T4 enables a data voltage of the data signal line D to be input to the third node N3.

In an exemplary implementation, a gate electrode of the fifth transistor T5 is connected to the first light emitting signal line E1, a first electrode of the fifth transistor T5 is connected with the first power supply line VDD, and the second electrode of the fifth transistor T5 is connected with the second node N2. A gate electrode of the sixth transistor T6 is connected with the second light emitting signal line E2, a first electrode of the sixth transistor T6 is connected with the third node N3, and a second electrode of the sixth transistor T6 is connected with the fourth node N4. When an on-level light emitting signal is applied to the first light emitting signal line E1 and the second light emitting signal line E2, the fifth transistor T5 and the sixth transistor T6 enable the light emitting device to emit light by forming a driving current path between the first power supply line VDD and the light emitting device.

The light emitting device EL may be an OLED, including a first electrode (an anode), an organic light emitting layer, and a second electrode (an cathode) which are stacked, or may be a QLED including a first electrode (an anode), a quantum dot light emitting layer, and a second electrode (a cathode) which are stacked. The first electrode of the light emitting device EL is connected to the fourth node N4 of the pixel drive circuit, and the second electrode of the light emitting device EL is connected to the second power supply line VSS.

In an exemplary implementation, the six transistors of the pixel drive circuit may be N-type transistors. Use of a same type of transistors in a pixel drive circuit may simplify a process flow, reduce process difficulties of the display substrate, and improve a yield of products.

In an exemplary implementation, the six transistors of the pixel drive circuit may be oxide thin film transistors. An active layer of the oxide thin film transistor may be made of an oxide semiconductor (Oxide). Oxide thin film transistors have the advantages of high electron mobility, low working voltage, low leakage characteristics, etc., and the use of a display substrate equipped with oxide thin film transistors can achieve low-frequency drive, reduce power consumption and improve display quality.

In some exemplary implementations, the first power supply line VDD may be configured to provide a constant first voltage signal to the pixel drive circuit, the second power supply line VSS may be configured to provide a constant second voltage signal to the pixel drive circuit, and the first voltage signal is greater than the second voltage signal. The initial signal line INIT may be configured to provide an initial voltage signal to the pixel drive circuit. The initial voltage signal may be a constant voltage signal, a magnitude of which may be between a magnitude of the first voltage signal provided by the first power supply line VDD and a magnitude of the second voltage signal provided by the second power supply line VSS, which is not limited here in the present disclosure.

In an exemplary implementation, taking a case that the first transistor T1 to the sixth transistor T6 included in the pixel drive circuit are all N-type transistors as an example, a working process of the pixel drive circuit may include following stages, i.e. a first stage A1, a second stage A2, and a third stage A3.

The first stage A1 is referred to as an initialization stage. A high-level signal provided by the first scan signal line S1 causes the first transistor T1 and the second transistor T2 to be turned on, and a high-level signal provided by the first light emitting signal line E1 causes the fifth transistor T5 to be turned on. The first transistor T1 is turned on so that the initial voltage signal provided by the initial signal line INIT is provided to the fourth node N4 to initialize the storage capacitor C and the light emitting device EL, clear the original data voltage in the second plate of the storage capacitor C, and clear a pre-stored voltage of the first electrode of the light emitting device EL, and initialization is completed, the light emitting device EL does not emit light. The second transistor T2 is turned on so that the first node N1 and the second node N2 are connected, and the fifth transistor T5 is turned on so that the first voltage signal output by the first power supply line VDD is charged into the first plate of the storage capacitor C through the fifth transistor T5, the second node N2 and the first node N1. Since the first plate of the storage capacitor C is at a high level, the third transistor T3 is turned on.

The second stage A2 is referred to as a data writing stage or a threshold compensation stage. The second scan signal line S2 provides a high-level signal to turn on the fourth transistor T4. The fourth transistor T4 is turned on so that the data voltage output from the data signal line D is provided to the first node N1 through the third node N3, the turned-on third transistor T3, the second node N2 and the turned-on second transistor T2, and the difference between the data voltage output from the data signal line D and the threshold voltage of the third transistor T3 is charged into the first plate of the storage capacitor C.

The third stage A3 is referred to as a light emitting stage. The first light emitting signal line E1 and the second light emitting signal line E2 provide high-level signals, so that the fifth transistor T5 and the sixth transistor T6 are turned on, and the first voltage signal output by the first power supply line VDD provides a drive voltage to the first electrode of the light emitting element EL through the turned-on fifth transistor T5, the third transistor T3 and the sixth transistor T6 to drive the light emitting element EL to emit light.

In a drive process of the pixel drive circuit, the current flowing through the light emitting element EL is independent of the threshold voltage of the third transistor T3, so that the pixel drive circuit can better compensate the threshold voltage of the third transistor T3.

In an exemplary implementation, in a direction perpendicular to the display substrate, the display substrate may include a drive circuit layer disposed on a base substrate, a light emitting structure layer disposed on a side of the drive circuit layer away from the base substrate, and an encapsulation structure layer disposed on a side of the light emitting structure layer away from the base substrate. **In** a direction parallel to the display substrate, the drive circuit layer may include circuit units constituting a plurality of unit rows and a plurality of unit columns, at least one circuit unit may include at least a pixel drive circuit, and at least one pixel drive circuit may include a storage capacitor and a plurality of oxide transistors. The light emitting structure layer may include a plurality of light emitting units constituting a plurality of light emitting rows and a plurality of light emitting columns, at least one light emitting unit may include a light emitting device, and the device may include at least an anode, an organic light emitting layer, and a cathode.

FIG. 5 is a schematic diagram of a planar structure of a display substrate according to an exemplary embodiment of the present disclosure, illustrating a structure of pixel drive circuits in three circuit units in an n-th unit row. As shown in FIG. 5, in an exemplary implementation, the drive circuit layer may include a plurality of circuit units, at least one circuit unit may include a pixel drive circuit, and the pixel drive circuit may be connected to a first scan signal line 61, a second scan signal line 62, a first light emitting signal line 63, a second light emitting signal line 64, an initial signal line 65, a first power supply line 71, and a data signal line 73, respectively. The first scan signal line 61 and the second scan signal line 62 are configured to provide a first scan signal and a second scan signal, respectively, to the pixel drive circuit. The first light emitting signal line 63 and the second light emitting signal line 64 are configured to provide a first light emitting signal and a second light emitting signal, respectively, to the pixel drive circuit. The initial signal line 65, the first power supply line 71 and the data signal line 73 are configured to provide an initial signal, a first power supply signal, and a data signal, respectively, to the pixel drive circuit.

In an exemplary implementation, the first scan signal line 61, the second scan signal line 62, the first light emitting signal line 63, the second light emitting signal line 64, and the initial signal line 65 may be in a shape of a line extending toward a first direction X, and the first power supply line 71 and the data signal line 73 may be in a shape of a polyline or a polyline extending toward a second direction Y, the first direction X being intersected with the second direction Y.

In the present disclosure, "A extends in a B direction" refers to that A may include a main portion and a secondary portion connected to the main portion, herein the main portion is a line, a line segment, or a strip-shaped body, the main portion extends in the B direction, and a length of the main portion extending in the B direction is greater than a length of the secondary portion extending in another direction. In following description, "A extends in a B direction" means "a main body portion of A extends in a B direction". In an exemplary implementation, the first direction X may be the unit row direction, and the second direction Y may be the unit column direction.

In an exemplary implementation, the pixel drive circuit may include at least a storage capacitor and a plurality of oxide transistors, and the plurality of oxide transistors may include a first transistor T1, a second transistor T2, a third transistor T3, a fourth transistor T4, a fifth transistor T5, and a sixth transistor T6. A gate electrode of the first transistor T1 and a gate electrode of the second transistor T2 are connected to the first scan signal line 61, a gate electrode of the fourth transistor T4 is connected to the second scan signal line 62, a gate electrode of the fifth transistor T5 is connected to the first light emitting signal line 63, and a gate electrode of the sixth transistor T6 is connected to the second light emitting signal line 64.

In an exemplary implementation, a first electrode of the first transistor T1 is connected to the initial signal line 65, a second electrode of the first transistor T1 is respectively connected to a second electrode of the sixth transistor T6 and a second plate of the storage capacitor, a first electrode of the second transistor T2 is respectively connected to a gate electrode of the third transistor T3 and a first plate of the storage capacitor, a second electrode of the second transistor T2 is respectively connected to a first electrode of the third transistor T3 and a second electrode of the fifth transistor T5, a second electrode of the third transistor T3 is respectively connected to a second electrode of the fourth transistor T4 and a first electrode of the sixth transistor T6, a first electrode of the fourth transistor T4 is connected to the data signal line 73, and a first electrode of the fifth transistor T5 is connected to the first power supply line 71. In an exemplary implementation, the gate electrode of the third transistor T3 and the first plate of the storage capacitor are of an integral structure.

In an exemplary implementation, in at least one circuit unit, the fourth transistor T4 and the fifth transistor T5 may be disposed on a side of the third transistor T3 in a direction opposite to the second direction Y, and the first transistor T1, the second transistor T2, and the sixth transistor T6 may be disposed on a side of the third transistor T3 in the second direction Y.

In an exemplary implementation, in at least one circuit unit, the fourth transistor T4 may be located on a side of the third transistor T3 in a direction opposite to the second direction Y, the fifth transistor T5 may be located on a side of the fourth transistor T4 away from the third transistor T3, the sixth transistor T6 may be disposed on a side of the third transistor T3 in the second direction Y, and the first transistor T1 and the second transistor T2 may be disposed on a side of the sixth transistor T6 away from the third transistor T3.

In an exemplary implementation, the drive circuit layer may further include at least one first power supply connection line 66 extending in the first direction X. The first power supply line 71 and the first power supply connection line 66 are connected to each other to form a net-like structure for transmitting the first power supply signal.

In an exemplary implementation, the drive circuit layer may further include at least one second power supply connection line 67 extending in the first direction X. The second power supply line 72 and the second power supply connection line 67 are connected to each other to form a net-like structure for transmitting a second power supply signal.

In an exemplary implementation, the drive circuit layer may further include at least one initial connection line 74 extending in the second direction Y. The initial signal line 65 and the initial connection line 74 are connected to each other to form a net-like structure for transmitting the initial signal.

In an exemplary implementation, in a direction perpendicular to the base substrate, the drive circuit layer includes at least a shielding conductive layer, a first conductive layer, a semiconductor layer, a second conductive layer, a third conductive layer (a first source-drain metal layer), and a fourth conductive layer (i.e., a second source-drain metal layer), which are sequentially disposed along a direction away from the base substrate.

In an exemplary implementation, the first scan signal line 61, the second scan signal line 62, the first light emitting signal line 63, the second light emitting signal line 64, and the initial signal line 65 may be disposed in the third conductive layer, and the first power supply line 71 and the data signal line 73 may be disposed in the fourth conductive layer.

In an exemplary implementation, at least one oxide transistor may include at least a bottom gate electrode and a top gate electrode, the bottom gate electrode may be disposed in the first conductive layer, and the top gate electrode may be disposed in the second conductive layer. The first scan signal line 61 or the second scan signal line 62 located in the third conductive layer is connected to the bottom gate electrode and the top gate electrode through a via, respectively.

In an exemplary implementation, the first transistor T1 may include at least a first bottom gate electrode and a first top gate electrode, and the second transistor T2 may include at least a second bottom gate electrode and a second top gate electrode. The first bottom gate electrode and the second bottom gate electrode may be disposed in the first conductive layer and have an interconnected integral structure. The first top gate electrode and the second top gate electrode may be disposed in the second conductive layer and have an interconnected integral structure.

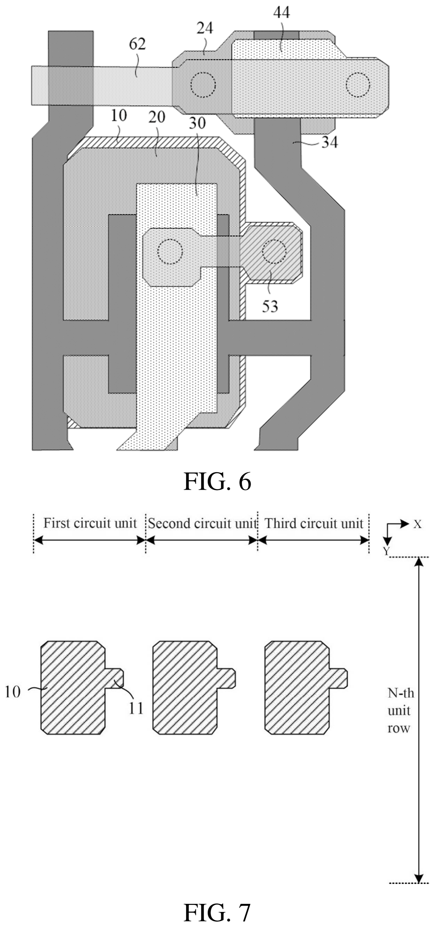

FIG. 6 is a schematic diagram of structures of the storage capacitor and the fourth transistor in FIG. 5. As shown in FIGS. 5 and 6, the storage capacitor may include a first sub-capacitor and a second sub-capacitor. The first sub-capacitor may include a first plate 10 and a second plate 20, and an orthographic projection of the first plate 10 on the base substrate is at least partially overlapped with an orthographic projection of the second plate 20 on the base substrate. The second sub-capacitor may include a second plate 20 and a third plate 30, and an orthographic projection of the second plate 20 on the base substrate is at least partially overlapped with an orthographic projection of the third plate 30 on the base substrate. The second plate 20 may serve as a gate electrode of the third transistor T3, and the first plate 10 is connected to the third plate 30.

In an exemplary implementation, the first plate 10 may be disposed in the shielding conductive layer, the second plate 20 may be disposed in the first conductive layer, and the third plate 30 may be disposed in the second conductive layer. The first plate 10 and the third plate 30 may be connected by the third connection electrode 53 disposed in the fourth conductive layer to form a sandwich structure with a three-layer metal layout, and the first sub-capacitor and the second sub-capacitor in a parallel structure constitute the storage capacitor.

In an exemplary implementation, a first terminal of the third connection electrode 53 is connected to the first plate 10 through a via, and a second terminal of the third connection electrode 53 is connected to the third plate 30 through another via.

In an exemplary implementation, the fourth transistor T4 may include at least a fourth bottom gate electrode 24, a fourth active layer 34, and a fourth top gate electrode 44. The fourth bottom gate electrode 24 may be disposed in the first conductive layer, the fourth active layer 34 may be disposed in the semiconductor layer, and the fourth top gate electrode 44 may be disposed in the second conductive layer, that is, the fourth bottom gate electrode 24 and the fourth top gate electrode 44 are disposed on upper and lower sides of the fourth active layer 34, respectively.

In an exemplary implementation, on one hand, the second scan signal line 62 located in the third conductive layer is connected to the fourth bottom gate electrode 24 through a via, and on the other hand, the second scan signal line 62 located in the third conductive layer is connected to the fourth top gate electrode 44 through another via, thus realizing that the second scan signal line 62 is connected to the bottom gate electrode and the top gate electrode of the fourth transistor T4 simultaneously. The second scan signal line 62 can control turn-on or turn-off of the fourth transistor T4.

Exemplary description is made below through a manufacturing process of the display substrate according to the exemplary embodiment. A "patterning process" mentioned in the present disclosure includes photoresist coating, mask exposure, development, etching, photoresist stripping, and the like for a metal material, an inorganic material, or a transparent conductive material, and includes organic material coating, mask exposure, development, and the like for an organic material. Deposition may be any one or more of sputtering, evaporation, and chemical vapor deposition; coating may be any one or more of spray coating, spin coating, and inkjet printing; and etching may be any one or more of dry etching and wet etching, which is not limited in present disclosure. A "thin film" refers to a layer of thin film made of a certain material on a base substrate using deposition, coating, or other processes. If the "thin film" does not need to be processed through a patterning process in the entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process. "A and B are provided in a same layer" in the present disclosure means that A and B are formed simultaneously through a same patterning process, and a "thickness" of a film layer is a dimension of the film layer in a direction perpendicular to a display substrate. In an exemplary implementation mode of the present disclosure, "an orthographic projection of B is within a range of an orthographic projection of A" or "an orthographic projection of A contains an orthographic projection of B" refers to that a boundary of the orthographic projection of B falls within a range of a boundary of the orthographic projection of A, or the boundary of the orthographic projection of A coincides with the boundary of the orthographic projection of B.

In an exemplary implementation, taking an n-th unit row including a first circuit unit, a second circuit unit, and a third circuit unit as an example, a manufacturing process of the display substrate may include the following operations.
(1) A pattern of a shielding conductive layer is formed. In an exemplary implementation, forming the pattern of the shielding conductive layer may include: depositing a shielding thin film on a base substrate, and patterning the shielding thin film by a patterning process to form the pattern of the shielding conductive layer on the base substrate, as shown in FIG. 7.

In an exemplary implementation, the pattern of the shielding conductive layer of each circuit unit in the display substrate may at least include a first plate 10 of the storage capacitor.

In an exemplary implementation, the first plate 10 may have a rectangular shape whose corners may be chamfered, and the first plate 71 may serve as a lower plate of the storage capacitor.

In an exemplary implementation, a first plate electrode 11 may be disposed on a side of the first plate 10 in a first direction X. A first terminal of the first plate electrode 11 is connected to the first plate 10, a second terminal of the first plate electrode 11 extends in a direction away from the first plate 10, and the first plate electrode 11 is configured to be connected to a third connection electrode formed subsequently.

In an exemplary implementation, the first plate 10 and the first plate electrode 11 of each circuit unit may be of an interconnected integral structure.

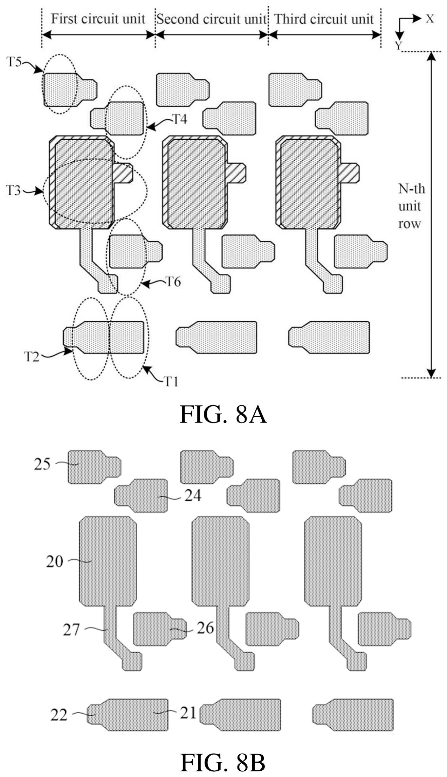

(2) A pattern of a first conductive layer is formed. In an exemplary implementation, forming the pattern of the first conductive layer may include: sequentially depositing a first insulation thin film and a first conductive thin film on the base substrate on which the aforementioned pattern is formed, and patterning the first conductive thin film through a patterning process to form a first insulation layer covering the pattern of the shielding conductive layer, and a pattern of a first conductive layer disposed on the first insulation layer, as shown in FIG. 8A and FIG. 8B. FIG. 8B is a schematic diagram of the first conductive layer in FIG. 8A. In an exemplary implementation, the first conductive layer may be referred to as a first gate metal (GATE1) layer.

In an exemplary implementation, the pattern of the first conductive layer of each circuit unit in the display substrate includes at least a second plate 20, a first bottom gate electrode 21, a second bottom gate electrode 22, a fourth bottom gate electrode 24, a fifth bottom gate electrode 25, a sixth bottom gate electrode 26, and a second plate electrode 27.

In an exemplary implementation, the second plate 20 may be in a shape of a block (for example, a rectangle), and an orthographic projection of the second plate 20 on the base substrate is at least partially overlapped with an orthographic projection of the first plate 10 on the base substrate. The second plate 20 may serve as an intermediate plate of the storage capacitor, and is configured to shield the channel region of the third transistor T3 to reduce the influence of light on electrical characteristics of the third transistor T3.

In an exemplary implementation, the first bottom gate electrode 21 may be in a shape of a block (for example, a rectangle), and may be located on a side of the second plate 20 in a second direction Y. The first bottom gate electrode 21 may serve as a bottom gate electrode of the first transistor T1, and is configured to shield the channel region of the first transistor T1 to reduce the influence of light on electrical characteristics of the first transistor T1.

In an exemplary implementation, the second bottom gate electrode 22 may be in a shape of a block (for example, a rectangle), and may be located on a side of the second plate 20 in the second direction Y. The second bottom gate electrode 22 may serve as a bottom gate electrode of the second transistor T2, and is configured to shield the channel region of the second transistor T2 to reduce the influence of light on electrical characteristics of the second transistor T2.

In an exemplary implementation, the fourth bottom gate electrode 24 may be in a shape of a block (for example, a rectangle), and may be located on a side of the second plate 20 in a direction opposite to the second direction Y. The fourth bottom gate electrode 24 may serve as a bottom gate electrode of the fourth transistor T4, and is configured to shield the channel region of the fourth transistor T4 to reduce the influence of light on electrical characteristics of the fourth transistor T4.

In an exemplary implementation, the fifth bottom gate electrode 25 may be in a shape of a block (for example, a rectangle), and may be located on a side of the second plate 20 in a direction opposite to the second direction Y. The fifth bottom gate electrode 25 may serve as a bottom gate electrode of the fifth transistor T5, and is configured to shield the channel region of the fifth transistor T5 to reduce the influence of light on electrical characteristics of the fifth transistor T5.

In an exemplary implementation, the sixth bottom gate electrode 26 may be in a shape of a block (for example, a rectangle), and may be located on a side of the second plate 20 in the second direction Y. The sixth bottom gate electrode 26 may serve as a bottom gate electrode of the sixth transistor T6, and is configured to shield the channel region of the sixth transistor T6 to reduce the influence of light on electrical characteristics of the sixth transistor T6.

In an exemplary implementation, the second plate electrode 27 may be in a shape of a polyline extending in the second direction Y. A first terminal of the second plate electrode 27 is connected to the second plate 20, a second terminal of the second plate electrode 27 extends toward the first bottom gate electrode 21, and the second plate electrode 27 is configured to be connected to a second connection electrode formed subsequently.

In an exemplary implementation, the second plate 20 and the second plate electrode 27 of each circuit unit may be of an interconnected integral structure.

In an exemplary implementation, the first bottom gate electrode 21 and the second bottom gate electrode 22 of each circuit unit may be of an interconnected integral structure.

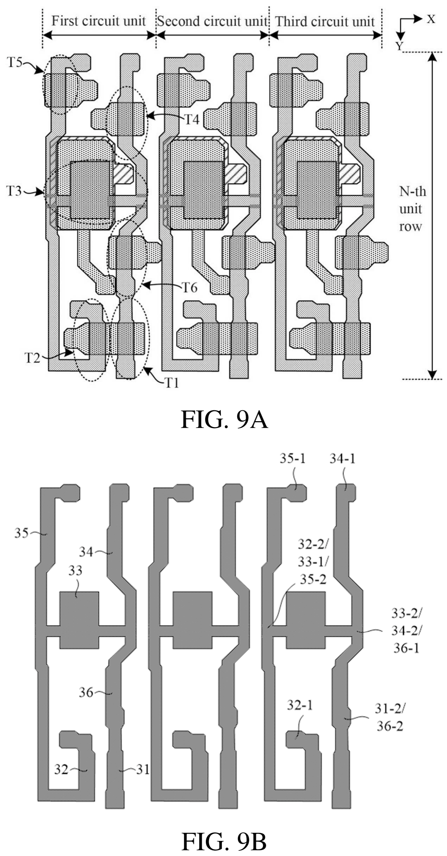

(3) A pattern of a semiconductor layer is formed. In an exemplary implementation, forming the pattern of the semiconductor layer may include: depositing sequentially a second insulation thin film and a semiconductor thin film on the base substrate on which the aforementioned patterns are formed, and patterning the semiconductor thin film through a patterning process to form a second insulation layer covering the first conductive layer, and a pattern of a semiconductor layer disposed on the second insulation layer, as shown in FIG.9A and FIG.9B, herein FIG.9B is a planar schematic diagram of the semiconductor layer in FIG.9A.

In an exemplary implementation, the pattern of the semiconductor layer of each circuit unit in the display substrate may include a first active layer 31 of the first transistor T1 to a sixth active layer 36 of the sixth transistor T6, and the first active layer 31 to the sixth active layer 36 are of an interconnected integral structure.

In an exemplary implementation, in the second direction Y, the first active layer 31, the second active layer 32, and the sixth active layer 36 may be located on a side of the third active layer 33 in the second direction Y, and the fourth active layer 34 and the fifth active layer 35 may be located on a side of the third active layer 33 in a direction opposite to the second direction Y.

In an exemplary implementation, in the first direction X, the first active layer 31, the fourth active layer 34 and the sixth active layer 36 may be located on a same side of the third active layer 33 in the first direction X, and the second active layer 32 and the fifth active layer 35 may be located on a same side of the third active layer 33 in a direction opposite to the first direction X.

In an exemplary implementation, the first active layer 31, the second active layer 32, the fourth active layer 34, the fifth active layer 35, and the sixth active layer 36 may be in a shape of a strip extending in the second direction Y. The third active layer 33 may be in a shape of a rectangle, and two sides of the third active layer 33 of the first direction X are connected to other active layers by connection strips.

In an exemplary implementation, in an exemplary implementation, an active layer of each transistor may include a first region, a second region, and a channel region located between the first region and the second region. An orthographic projection of the first active layer 31 on the base substrate is at least partially overlapped with an orthographic projection of the first bottom gate electrode 21 on the base substrate, and an overlapping region of the first active layer 31 serves as a channel region of the first transistor T1. An orthographic projection of the second active layer 32 on the base substrate is at least partially overlapped with an orthographic projection of the second bottom gate electrode 22 on the base substrate, and an overlapping region of the second active layer 32 serves as a channel region of the second transistor T2. An orthographic projection of the third active layer 33 on the base substrate is at least partially overlapped with an orthographic projection of the second plate 20 on the base substrate. An orthographic projection of the fourth active layer 34 on the base substrate is at least partially overlapped with an orthographic projection of the fourth bottom gate electrode 24 on the base substrate, and an overlapping region of the fourth active layer 34 serves as a channel region of the fourth transistor T4. An orthographic projection of the fifth active layer 35 on the base substrate is at least partially overlapped with an orthographic projection of the fifth bottom gate electrode 25 on the base substrate, and an overlapping region of the fifth active layer 35 serves as a channel region of the fifth transistor T5. An orthographic projection of the sixth active layer 36 on the base substrate is at least partially overlapped with an orthographic projection of the sixth bottom gate electrode 26 on the base substrate, and an overlapping region of the sixth active layer 36 serves as a channel region of the sixth transistor T6.

In an exemplary implementation, a second region 31-2 of the first active layer may serve as a second region 36-2 of the sixth active layer, i.e., the second region 31-2 of the first active layer and the second region 36-2 of the sixth active layer may be connected to each other. A first region 33-1 of the third active layer may serve as a second region 32-2 of the second active layer and a second region 35-2 of the fifth active layer simultaneously, i.e., the second region 32-2 of the second active layer, the first region 33-1 of the third active layer and the second region 35-2 of the fifth active layer may be connected to each other. A second region 33-2 of the third active layer may serve as a second region 34-2 of the fourth active layer and a first region 36-1 of the sixth active layer simultaneously, i.e., the second region 33-2 of the third active layer, the second region 34-2 of the fourth active layer and the first region 36-1 of the sixth active layer may be connected to each other. A first region 31-1 of the first active layer, a first region 32-1 of the second active layer, a first region 34-1 of the fourth active layer 34 and the first region 35-1 of the fifth active layer 35 may be arranged separately.

In an exemplary implementation, the semiconductor layer may be made of an oxide, i.e., the first transistor T1 to the sixth transistor T6 are oxide transistors. Oxide transistors have advantages of high electron mobility, low working voltage, low leakage characteristics, etc. In an exemplary implementation, the oxide may be any one or more of following: Indium Gallium Zinc Oxide (InGaZnO), Indium Gallium Zinc Oxynitride (InGaZnON), Zinc Oxide (ZnO), Zinc Oxynitride (ZnON), Zinc Tin Oxide (ZnSnO), Cadmium Tin Oxide (CdSnO), Gallium Tin Oxide (GaSnO), Titanium Tin Oxide (TiSnO), Copper Aluminum Oxide (CuAlO), Strontium Copper Oxide (SrCuO), Lanthanum Copper Oxysulfide (LaCuOS), Gallium Nitride (GaN), Indium Gallium Nitride (InGaN), Aluminum Gallium Nitride (AlGaN), and Indium Gallium Aluminum Nitride (InGaAlN). In some possible implementations, the semiconductor thin film may be made of Indium Gallium Zinc Oxide (IGZO), an electron mobility of Indium Gallium Zinc Oxide (IGZO) is higher than an electron mobility of amorphous silicon.

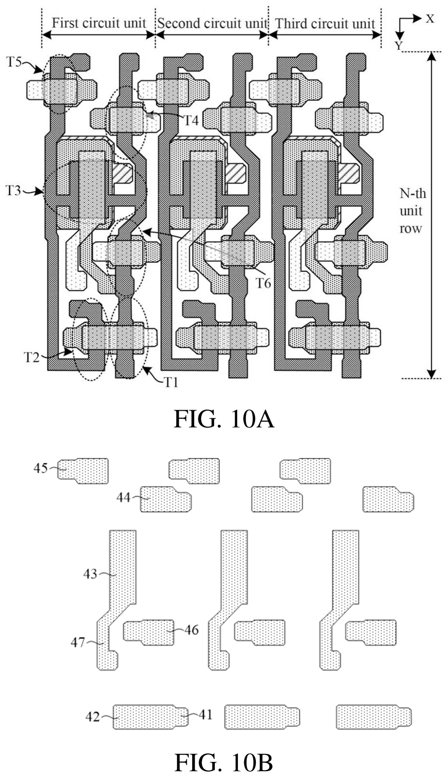

(4) A pattern of a first conductive layer is formed. In an exemplary implementation, forming the pattern of the first conductive layer may include: depositing sequentially a third insulation thin film and a second conductive thin film on the base substrate on which the aforementioned patterns are formed, and patterning the second conductive thin film through a patterning process to form a third insulation layer that covers the pattern of the semiconductor layer, and a pattern of a second conductive layer disposed on the third insulation layer, as shown in FIG. 10A and FIG. 10B, herein FIG. 10B is a planar schematic diagram of the second conductive layer in FIG. 10A. In an exemplary implementation, the first conductive layer may be referred to as a second gate metal (GATE2) layer.

In an exemplary implementation, the pattern of the second conductive layer of each circuit unit in the display substrate includes at least a third plate 30, a first top gate electrode 41, a second top gate electrode 42, a fourth top gate electrode 44, a fifth top gate electrode 45, a sixth top gate electrode 46, and a third plate electrode 47.

In an exemplary implementation, the third plate 30 may be in a shape of a block (e.g., a rectangle), and an orthographic projection of the third plate 30 on the base substrate is at least partially overlapped with an orthographic projection of the second plate 20 on the base substrate. On one hand, the third plate 30 may serve as an upper plate of the storage capacitor, and on the other hand, the third plate 30 may serve as a gate electrode of the third transistor T3. An orthographic projection of the third plate 30 on the base substrate is at least partially overlapped with an orthographic projection of the third active layer 33 on the base substrate, that is, the gate electrode of the third transistor T3 and the third plate of the storage capacitor are of an integral structure.

In an exemplary implementation, the first top gate electrode 41 may be in a shape of a block (such as a rectangle), an orthographic projection of the first top gate electrode 41 on the base substrate is at least partially overlapped with an orthographic projection of the first active layer 31 on the base substrate, and the orthographic projection of the first top gate electrode 41 on the base substrate is at least partially overlapped with an orthographic projection of the first bottom gate electrode 21 on the base substrate. The first top gate electrode 41 may serve as a top gate electrode of the first transistor T1, and may be configured to be connected to a first scan signal line formed subsequently.

In an exemplary implementation, the second top gate electrode 42 may be in a shape of a block (such as a rectangle), an orthographic projection of the second top gate electrode 42 on the base substrate is at least partially overlapped with an orthographic projection of the second active layer 32 on the base substrate, and the orthographic projection of the second top gate electrode 42 on the base substrate is at least partially overlapped with an orthographic projection of the second bottom gate electrode 22 on the base substrate. The second top gate electrode 42 may serve as a top gate electrode of the second transistor T2, and may be configured to be connected to a first scan signal line formed subsequently.

In an exemplary implementation, the fourth top gate electrode 44 may be in a shape of a block (such as a rectangle), an orthographic projection of the fourth top gate electrode 44 on the base substrate is at least partially overlapped with an orthographic projection of the fourth active layer 34 on the base substrate, and the orthographic projection of the fourth top gate electrode 44 on the base substrate is at least partially overlapped with an orthographic projection of the fourth bottom gate electrode 24 on the base substrate. The fourth top gate electrode 44 may serve as a top gate electrode of the fourth transistor T4, and may be configured to be connected to a second scan signal line formed subsequently.

In an exemplary implementation, the fifth top gate electrode 45 may be in a shape of a block (such as a rectangle), an orthographic projection of the fifth top gate electrode 45 on the base substrate is at least partially overlapped with an orthographic projection of the fifth active layer 35 on the base substrate, and the orthographic projection of the fifth top gate electrode 45 on the base substrate is at least partially overlapped with an orthographic projection of the fifth bottom gate electrode 25 on the base substrate. The fifth top gate electrode 45 is configured to be connected to a first light emitting signal line formed subsequently.

In an exemplary implementation, the sixth top gate electrode 46 may be in a shape of a block (such as a rectangle), an orthographic projection of the sixth top gate electrode 46 on the base substrate is at least partially overlapped with an orthographic projection of the sixth active layer 36 on the base substrate, and the orthographic projection of the sixth top gate electrode 46 on the base substrate is at least partially overlapped with an orthographic projection of the sixth bottom gate electrode 26 on the base substrate. The sixth top gate electrode 46 is configured to be connected to a second light emitting signal line formed subsequently.

In an exemplary implementation, the third plate electrode 47 may be in a shape of a polyline extending in the second direction Y. A first terminal of the third plate electrode 47 is connected to the third plate 30, a second terminal of the third plate electrode 47 extends toward the second top gate electrode 42, and the third plate electrode 47 is configured to be connected through a first connection electrode formed subsequently.

In an exemplary implementation, the third plate 30 and the third plate electrode 47 of each circuit unit may be of an interconnected integral structure.

In an exemplary implementation, the first top gate electrode 41 and the second top gate electrode 42 of each circuit unit may be of an interconnected integral structure.

In an exemplary implementation, after the pattern of the second conductive layer is formed, a conductive treatment may be performed on the semiconductor layer by using the second conductive layer as a shield. A region of the semiconductor layer, which is shielded by the second conductive layer, forms channel regions of the first transistor T1 to the sixth transistor T6, and a region of the semiconductor layer, which is not shielded by the second conductive layer, is made to be conductive, that is, first regions and second regions of the first transistor T1 to the sixth active layer are all made to be conductive.

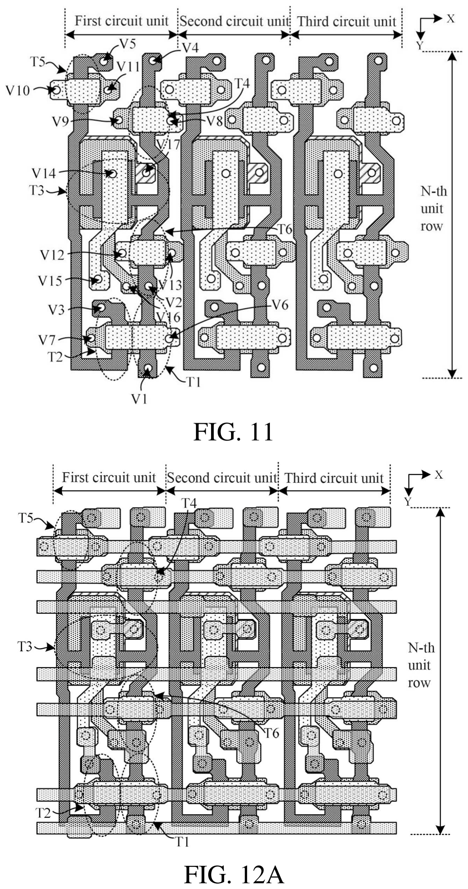

(5) A pattern of a fourth insulation layer is formed. In an exemplary implementation, forming the pattern of the fourth insulation layer may include: depositing a fourth insulation thin film on the base substrate on which the aforementioned patterns are formed, and patterning the fourth insulation thin film by a patterning process, to form a fourth insulation layer covering the second conductive layer, and a plurality of vias are provided on the fourth insulation layer, as shown in FIG. 11.

In an exemplary implementation mode, the plurality of vias at least includes: a first via V1, a second via V2, a third via V3, a fourth via V4, a fifth via V5, a sixth via V6, a seventh via V7, an eighth via V8, a ninth via V9, a tenth via V10, an eleventh via V11, a twelfth via V12, a thirteenth via V13, a fourteenth via V14, a fifteenth via V15, a sixteenth via V16 and a seventeenth via V17.

In an exemplary implementation, an orthographic projection of the first via V1 on the base substrate is within a range of an orthographic projection of a first region of the first active layer on the base substrate, the fourth insulation layer and the third insulation layer within the first via V1 is etched away to expose a surface of the first region of the first active layer, and the first via V1 is configured such that an initial signal line formed subsequently is connected to the first region of the first active layer through the via V1.

In an exemplary implementation, an orthographic projection of the second via V2 on the base substrate is within a range of an orthographic projection of a second region of the first active layer (also a second region of the sixth active layer) on the base substrate, the fourth insulation layer and the third insulation layer within the second via V2 are etched away to expose a surface of the second region of the first active layer, and the second via V2 is configured such that a second connection electrode formed subsequently is connected to the second region of the first active layer (also the second region of the sixth active layer) through the via V2.

In an exemplary implementation, an orthographic projection of the third via V3 on the base substrate is within a range of an orthographic projection of a first region of the second active layer on the base substrate, the fourth insulation layer and the third insulation layer within the third via V3 are etched away to expose a surface of the first region of the second active layer, and the third via V3 is configured such that a first connection electrode formed subsequently is connected to the first region of the second active layer through the via V3.

In an exemplary implementation, an orthographic projection of the fourth via V4 on the base substrate is within a range of an orthographic projection of a first region of the fourth active layer on the base substrate, the fourth insulation layer and the third insulation layer within the fourth via V4 are etched away to expose a surface of the first region of the fourth active layer, and the fourth via V4 is configured such that a fourth connection electrode formed subsequently is connected to the first region of the fourth active layer through the via V4.

In an exemplary implementation, an orthographic projection of the fifth via V5 on the base substrate is within a range of an orthographic projection of a first region of the fifth active layer on the base substrate, the fourth insulation layer and the third insulation layer within the fifth via V5 are etched away to expose a surface of the first region of the fifth active layer, and the fifth via V5 is configured such that a fifth connection electrode formed subsequently is connected to the first region of the fifth active layer through the via V5.

In an exemplary implementation, an orthographic projection of the sixth via V6 on the base substrate is within a range of an orthographic projection of the first top gate electrode 41 on the base substrate, the fourth insulation layer within the sixth via V6 is etched away to expose a surface of the first top gate electrode 41, and the sixth via V6 is configured such that a first scan signal line formed subsequently is connected to the first top gate electrode 41 through the via V6.

In an exemplary implementation, an orthographic projection of the seventh via V7 on the base substrate is within a range of an orthographic projection of the second bottom gate electrode 22 on the base substrate, the fourth insulation layer, the third insulation layer, and the second insulation layer within the seventh via V7 are etched away to expose a surface of the second bottom gate electrode 22, and the seventh via V7 is configured such that a first scan signal line formed subsequently is connected to the second bottom gate electrode 22 through the via V7.

In an exemplary implementation, an orthographic projection of the eighth via V8 on the base substrate is within a range of an orthographic projection of the fourth top gate electrode 44 on the base substrate, the fourth insulation layer within the eighth via V8 is etched away to expose a surface of the fourth top gate electrode 44, and the eighth via V8 is configured such that a second scan signal line formed subsequently is connected to the fourth top gate electrode 44 through the via V8.

In an exemplary implementation, an orthographic projection of the ninth via V9 on the base substrate is within a range of an orthographic projection of the fourth bottom gate electrode 24 on the base substrate, the fourth insulation layer, the third insulation layer, and the second insulation layer within the ninth via V9 are etched away to expose a surface of the fourth bottom gate electrode 24, and the ninth via V9 is configured such that a second scan signal line formed subsequently is connected to the fourth bottom gate electrode 24 through the via V9.

In an exemplary implementation, an orthographic projection of the tenth via V10 on the base substrate is within a range of an orthographic projection of the fifth top gate electrode 45 on the base substrate, the fourth insulation layer within the tenth via V10 is etched away to expose a surface of the fifth top gate electrode 45, and the tenth via V10 is configured such that a first light emitting signal line formed subsequently is connected to the fifth top gate electrode 45 through the via V10.

In an exemplary implementation, an orthographic projection of the eleventh via V11 on the base substrate is within a range of an orthographic projection of the fifth bottom gate electrode 25 on the base substrate, the fourth insulation layer, the third insulation layer, and the second insulation layer within the eleventh via V11 are etched away to expose a surface of the fifth bottom gate electrode 25, and the eleventh via V11 is configured such that a first light emitting signal line formed subsequently is connected to the fifth bottom gate electrode 25 through the via V11.

In an exemplary implementation, an orthographic projection of the twelfth via V12 on the base substrate is within a range of an orthographic projection of the sixth top gate electrode 46 on the base substrate, the fourth insulation layer within the twelfth via V12 is etched away to expose a surface of the sixth top gate electrode 46, and the twelfth via V12 is configured such that a second light emitting signal line formed subsequently is connected to the sixth top gate electrode 46 through the via V12.

In an exemplary implementation, an orthographic projection of the thirteenth via V13 on the base substrate is within a range of an orthographic projection of the sixth bottom gate electrode 26 on the base substrate, the fourth insulation layer, the third insulation layer, and the second insulation layer within the thirteenth via V13 are etched away to expose a surface of the sixth bottom gate electrode 26, and the thirteenth via V13 is configured such that a second light emitting signal line formed subsequently is connected to the sixth bottom gate electrode 26 through the via V13.

In an exemplary implementation, an orthographic projection of the fourteenth via V14 on the base substrate is within a range of an orthographic projection of the third plate 30 on the base substrate, the fourth insulation layer within the fourteenth via V14 is etched away to expose a surface of the third plate 30, and the fourteenth via V14 is configured such that a third connection electrode formed subsequently is connected to the third plate 30 through the via V14.

In an exemplary implementation, an orthographic projection of the fifteenth via V15 on the base substrate is within a range of an orthographic projection of the third plate electrode 47 on the base substrate, the fourth insulation layer within the fifteenth via V15 is etched away to expose a surface of the third plate electrode 47, and the fifteenth via V15 is configured such that a first connection electrode formed subsequently is connected to the third plate electrode 47 through the via V15.

In an exemplary implementation, an orthographic projection of the sixteenth via V16 on the base substrate is within a range of an orthographic projection of the second plate electrode 27 on the base substrate, the fourth insulation layer, the third insulation layer, and the second insulation layer within the sixteenth via V16 are etched away to expose a surface of the second plate electrode 27, and the sixteenth via V16 is configured such that a second connection electrode formed subsequently is connected to the second plate electrode 27 through the via V16.

In an exemplary implementation, an orthographic projection of the seventeenth via V17 on the base substrate is within a range of an orthographic projection of a plate connection block 11 of the first plate 10 on the base substrate, the fourth insulation layer, the third insulation layer, the second insulation layer, and the first insulation layer within the seventeenth via V17 are etched away to expose a surface of the plate connection block 11, and the seventeenth via V17 is configured such that a third connection electrode formed subsequently is connected to the plate connection block 11 through the via V17.

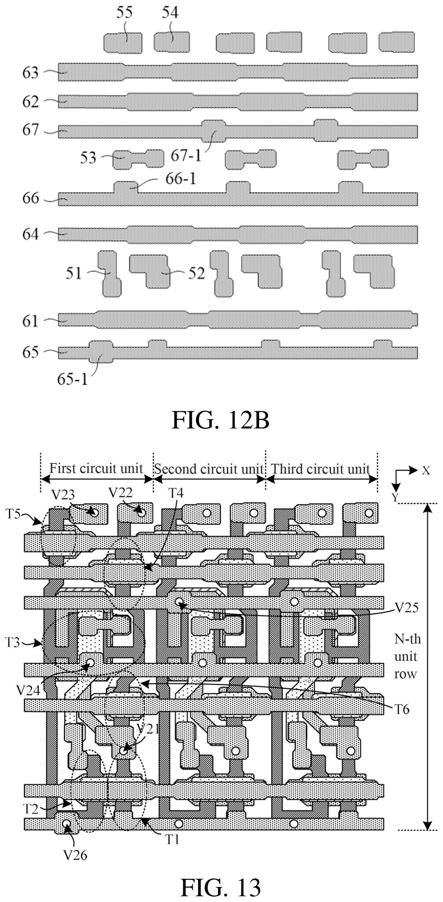

(6) A pattern of a third conductive layer is formed. In an exemplary implementation, forming the third conductive layer may include: depositing a third conductive thin film on the base substrate on which the aforementioned patterns are formed, and patterning the third conductive thin film through a patterning process to form a third conductive layer disposed on the fourth insulation layer, as shown in FIG. 12A and FIG. 12B, herein FIG. 12B is a planar schematic diagram of the third conductive layer in FIG. 12A. In an exemplary implementation, the third conductive layer may be referred to as a first source-drain metal (SD1) layer.

In an exemplary implementation, the third conductive layer of each circuit unit includes at least a first connection electrode 51, a second connection electrode 52, a third connection electrode 53, a fourth connection electrode 54, a fifth connection electrode 55, a first scan signal line 61, a second scan signal line 62, a first light emitting signal line 63, a second light emitting signal line 64, an initial signal line 65, a first power supply connection line 66, and a second power supply connection line 67.

In an exemplary implementation, the first scan signal line 61, the second scan signal line 62, the first light emitting signal line 63, the second light emitting signal line 64, the initial signal line 65, the first power supply connection line 66, and the second power supply connection line 67 may be in a shape of a straight line or a polyline extending in the first direction X. The second scan signal line 62 and the first light emitting signal line 63 may be located on a side of the third transistor T3 in a direction opposite to the second direction Y, and the first scan signal line 61, the second light emitting signal line 64, and the initial signal line 65 may be located on a side of the third transistor T3 in the second direction Y.

In an exemplary implementation, the first light emitting signal line 63 may be located on a side of the second scan signal line 62 away from the third transistor T3, the first scan signal line 61 may be located on a side of the second light emitting signal line 64 away from the third transistor T3, and the initial signal line 65 may be located on a side of the first scan signal line 61 away from the third transistor T3.

In an exemplary implementation, the first power supply connection line 66 and the second power supply connection line 67 may be located between the second scan signal line 62 and the second light emitting signal line 64, the first power supply connection line 66 may be located on a side of the second power supply connection line 67 away from the second scan signal line 62, and the second power supply connection line 67 may be located on a side of the first power supply connection line 66 away from the second light emitting signal line 64.

In an exemplary implementation, an orthographic projection of the first scan signal line 61 on the base substrate is at least partially overlapped with orthographic projections of the first bottom gate electrode 21, the second bottom gate electrode 22, the first top gate electrode 41, and the second top gate electrode 42 on the base substrate. On one hand, the first scan signal line 61 is connected to the first top gate electrode 41 in each circuit unit through the sixth via V6, and on the other hand, the first scan signal line 61 is connected to the second bottom gate electrode 22 in each circuit unit through the seventh via V7. Since the first bottom gate electrode 21 and the second bottom gate electrode 22 are connected to each other, and the first top gate electrode 41 and the second top gate electrode 42 are connected to each other, it is realized that the first scan signal line 61 is connected to the bottom gate electrode and the top gate electrode of the first transistor T1 simultaneously, and connected to the bottom gate electrode and the top gate electrode of the second transistor T2 simultaneously, so that the first scan signal line 61 can simultaneously control turn-on or turn-off of the first transistor T1.

In an exemplary implementation, an orthographic projection of the second scan signal line 62 on the base substrate is at least partially overlapped with orthographic projections of the fourth bottom gate electrode 24 and the fourth top gate electrode 44 on the base substrate. On one hand, the second scan signal line 62 is connected to the fourth top gate electrode 44 in each circuit unit through the eighth via V8, and on the other hand, the second scan signal line 62 is connected to the fourth bottom gate electrode 24 in each circuit unit through the ninth via V9, thus realizing that the second scan signal line 62 is connected to the bottom gate electrode and the top gate electrode of the fourth transistor T4 simultaneously. The second scan signal line 62 can control turn-on or turn-off of the fourth transistor T4.

In an exemplary implementation, in the present disclosure, by disposing the first scan signal line 61 and the second scan signal line 62 in the first source-drain metal (SD1) layer, resistances of the first scan signal line 61 and the second scan signal line 62 are reduced effectively, voltage drops of the first scan signal and the second scan signal are reduced, and the compensation speed is improved effectively when a data signal is written by a data signal line to the fourth transistor T4 and threshold voltage compensation is performed synchronously.

In an exemplary implementation, an orthographic projection of the first light emitting signal line 63 on the base substrate is at least partially overlapped with orthographic projections of the fifth bottom gate electrode 25 and the fifth top gate electrode 45 on the base substrate. On one hand, the first light emitting signal line 63 is connected to the fifth top gate electrode 45 in each circuit unit through the tenth via V10, and on the other hand, the first light emitting signal line 63 is connected to the fifth bottom gate electrode 25 in each circuit unit through the eleventh via V11 on the other hand, thus realizing that the first light emitting signal line 63 is connected to the bottom gate electrode and the top gate electrode of the fifth transistor T5 simultaneously. The first light emitting signal line 63 can control turn-on or turn-off of the fourth transistor T5.

In an exemplary implementation, an orthographic projection of the second light emitting signal line 64 on the base substrate is at least partially overlapped with orthographic projections of the sixth bottom gate electrode 26 and the sixth top gate electrode 46 on the base substrate. On one hand, the second light emitting signal line 64 is connected to the sixth top gate electrode 46 in each circuit unit through the twelfth via V12, and on the other hand, the second light emitting signal line 64 is connected to the sixth bottom gate electrode 26 in each circuit unit through the thirteenth via V13, thus realizing that the second light emitting signal line 64 is connected to the bottom gate electrode and the top gate electrode of the sixth transistor T6 simultaneously. The second light emitting signal line 64 can control turn-on or turn-off of the sixth transistor T6.

In an exemplary implementation, the initial signal line 65 is connected to the first region of the first active layer in each circuit unit through the first via V1, thus realizing that an initial signal can be written by the initial signal line 65 to the first electrode of the first transistor T1. In at least one circuit unit, the initial signal line 65 may also be connected with an initial connection block 65-1. The initial connection block 65-1 may be in a shape of a block (for example, a rectangle), and the initial connection block 65-1 is configured to be connected to a subsequently formed initial connection line.

In an exemplary implementation, an orthographic projection of the first power supply connection line 66 on the base substrate is at least partially overlapped with an orthographic projection of the third plate 30 on the base substrate. A first connection block 66-1 may be disposed on a side of the first power supply connection line 66 close to the second power supply connection line 67, and the first connection block 66-1 may be disposed in each circuit unit. A first end of the first connection block 66-1 is connected to the first power supply connection line 66, a second end of the first connection block 66-1 extends toward the second power supply connection line 67, and the first connection block 66-1 is configured to be connected to a subsequently formed first power supply line.

In an exemplary implementation, an orthographic projection of the second power supply connection line 67 on the base substrate is at least partially overlapped with an orthographic projection of the third plate 30 on the base substrate. In at least one circuit unit, the second power supply connection line 67 may also be connected with a second connection block 67-1. The second connection block 67-1 may be in a shape of a block (such as a rectangle), and the second connection block 67-1 is configured to be connected to a subsequently formed second power supply line.

In an exemplary implementation, the first connection electrode 51 may be in a shape of a strip in which a main body portion extends in the second direction Y, a first terminal of the first connection electrode 51 is connected to the first region of the second active layer through the third via V3, and a second terminal of the first connection electrode 51 is connected to the third plate electrode 47 through the fifteenth via V15. Due to the connection between the third plate electrode 47 and the third plate 30, the first connection electrode 51 enables the third plate 30 and the first electrode of the second transistor T2 to have a same potential, and the first connection electrode 51 may serve as the first node N1 of the pixel drive circuit.

In an exemplary implementation, the second connection electrode 52 may be in a shape of a block, a first terminal of the second connection electrode 52 is connected to the second region of the first active layer (also the second region of the sixth active layer) through the second via V2, and a second terminal of the second connection electrode 52 is connected to the second plate electrode 27 through the sixteenth via V16. Since the second plate electrode 27 is connected to the second plate 20, the second connection electrode 52 enables the second plate 20, the second electrode of the first transistor T1, and the second electrode of the sixth transistor T6 to have a same potential, and the second connection electrode 52 may serve as the fourth node N4 of the pixel drive circuit.

In an exemplary implementation, the third connection electrode 53 may be in a shape of a strip in which a main body portion extends in the first direction X, a first terminal of the third connection electrode 53 is connected to the third plate 30 through the fourteenth via V14, and a second terminal of the third connection electrode 53 is connected to the plate connection block 11 through the seventeenth via V17. Since the plate connection block 11 is connected to the first plate 10, the connection between the first plate 10 and the third plate 30 is realized, and the first plate 10 and the third plate 30 have a same potential.

In an exemplary implementation, the fourth connection electrode 54 may be in a shape of a strip in which a main body portion extends in the first direction X, and may be located on a side of the first light emitting signal line 63 away from the third plate 30. The fourth connection electrode 54 is connected to the first region of the fourth active layer through the fourth via V4, and the fourth connection electrode 54 is configured to be connected to a subsequently formed data signal line.

In an exemplary implementation, the fifth connection electrode 55 may be in a shape of a strip in which a main body portion extends in the first direction X, and may be located on a side of the first light emitting signal line 63 away from the third plate 30. The fifth connection electrode 55 is connected to the first region of the fifth active layer through the fifth via V5, and the fifth connection electrode 55 is configured to be connected to a subsequently formed first power supply line.

In the exemplary implementation, since the first plate 10 is connected to the third plate 30, and the third plate 30 is connected to the first region of the second active layer through the first connection electrode 51, the first plate 10 and the third plate 30 have a potential of the first node N1 of the pixel drive circuit. Since the second plate 20 is connected to the second region of the first active layer (also the second region of the sixth active layer) through the second connection electrode 52, the second plate 20 has a potential of the fourth node N4 of the pixel drive circuit. In this way, the first plate 10 having the potential of the first node N1 and the second plate 20 having the potential of the fourth node N4 form a first sub-capacitor of a storage capacitor, the second plate 20 having the potential of the fourth node N4 and the third plate 30 having the potential of the first node N1 form a second sub-capacitor of a storage capacitor, and the first sub-capacitor and the second sub-capacitor connected in parallel form a storage capacitor of the pixel drive circuit.

(7) Patterns of a fifth insulation layer and a first planarization layer are formed. In an exemplary implementation, forming the patterns of the fifth insulation layer and the first planarization layer may include: first depositing a fifth insulation thin film on the base substrate on which the aforementioned patterns are formed, then coating a first planarization thin film, and patterning the first planarization thin film and the fifth insulation thin film by a patterning process to form a fifth insulation layer that covers the pattern of the third conductive layer and a first planarization layer disposed on the fifth insulation layer, herein the first planarization layer and the fifth insulation layer are provided with a plurality of vias, as shown in FIG. 13.

**In** an exemplary implementation, the plurality of vias in each circuit unit include at least a twenty-first via V21, a twenty-second via V22, a twenty-third via V23, and a twenty-fourth via V24.

**In** an exemplary implementation, an orthographic projection of the twenty-first via V21 on the base substrate is within a range of an orthographic projection of the second connection electrode 52 on the base substrate, the first planarization layer and the fifth insulation layer within the twenty-first via V21 are etched away to expose a surface of the second connection electrode 52, and the twenty-first via V21 is configured such that an anode connection electrode formed subsequently is connected to the second connection electrode 52 through the via V21.

In an exemplary implementation, an orthographic projection of the twenty-second via V22 on the base substrate is within a range of an orthographic projection of the fourth connection electrode 54 on the base substrate, the first planarization layer and the fifth insulation layer within the twenty-second via V22 are etched away to expose a surface of the fourth connection electrode 54, and the twenty-second via V22 is configured such that a data signal line formed subsequently is connected to the fourth connection electrode 54 through the via V22.

In an exemplary implementation, an orthographic projection of the twenty-third via V23 on the base substrate is within a range of an orthographic projection of the fifth connection electrode 55 on the base substrate, the first planarization layer and the fifth insulation layer within the twenty-third via V23 are etched away to expose a surface of the fifth connection electrode 55, and the twenty-third via V23 is configured such that a first power supply line formed subsequently is connected to the fifth connection electrode 55 through the via V23.

In an exemplary implementation, an orthographic projection of the twenty-fourth via V24 on the base substrate is within a range of an orthographic projection of the first connection block 66-1 of the first power supply connection line 66 on the base substrate, the first planarization layer and the fifth insulation layer within the twenty-fourth via V24 are etched away to expose a surface of the first connection block 66-1, and the twenty-fourth via V24 is configured such that a first power supply line formed subsequently is connected to the first connection block 66-1 through the via V24.

In an exemplary implementation, at least one circuit unit may also include a twenty-fifth via V25 and a twenty-sixth via V26.

In an exemplary implementation, an orthographic projection of the twenty-fifth via V25 on the base substrate is within a range of an orthographic projection of the second connection block 67-1 of the second power supply connection line 67 on the base substrate, the first planarization layer and the fifth insulation layer within the twenty-fifth via V25 are etched away to expose a surface of the second connection block 67-1, and the twenty-fifth via V25 is configured such that a second power supply line formed subsequently is connected to the second connection block 67-1 through the via V25.

In an exemplary implementation, an orthographic projection of the twenty-sixth via V26 on the base substrate is within a range of an orthographic projection of the initial connection block 65-1 on the base substrate, the first planarization layer and the fifth insulation layer within the twenty-sixth via V26 are etched away to expose a surface of the initial connection block 65-1, and the twenty-sixth via V26 is configured such that an initial connection line formed subsequently is connected to the initial connection block 65-1 through the via V26.

In an exemplary implementation, the twenty-fifth via V25 may be disposed in the second circuit unit and the third circuit unit, and the twenty-sixth via V26 may be disposed in the first circuit unit.

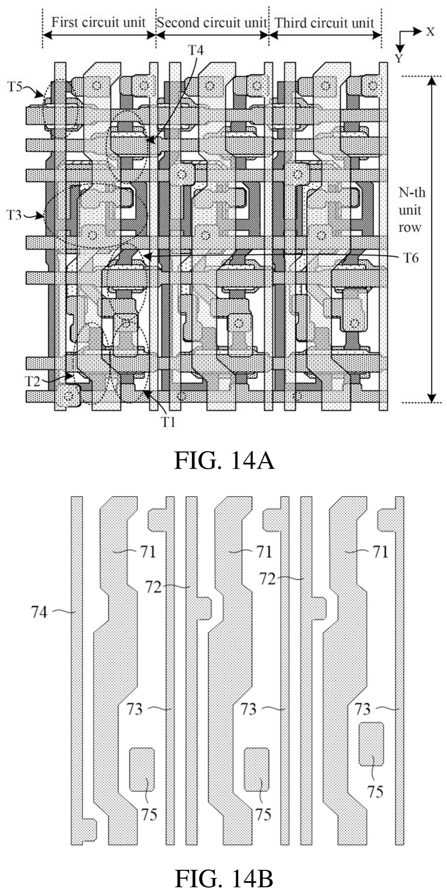

(8) A pattern of a fourth conductive layer is formed. In an exemplary implementation, forming the fourth conductive layer may include: depositing a fourth conductive thin film on the base substrate on which the aforementioned patterns are formed, and patterning the fourth conductive thin film through a patterning process to form a fourth conductive layer disposed on the first planarization layer, as shown in FIG. 14A and FIG. 14B, herein FIG. 14B is a planar schematic diagram of the fourth conductive layer in FIG. 14A. In an exemplary implementation, the fourth conductive layer may be referred to as a second source-drain metal (SD2) layer.

In an exemplary implementation, the fourth conductive layer of each circuit unit includes, at least, a first power supply line 71, a data signal line 73, and an anode connection electrode 75.

In an exemplary implementation, the first power supply line 71 may be in a shape of a polyline in which a main body portion extends in the second direction Y. On one hand, the first power supply line 71 is connected to the fifth connection electrode 55 through the twenty-third via V23, and on the other hand, the first power supply line 71 is connected to the first connection block 66-1 through the twenty-fourth via V24. Since the fifth connection electrode 55 is connected to the first region of the fifth active layer through a via, it is realized that a constant first voltage signal can be written by the first power supply line 71 to the first electrode of the fifth transistor T5. Since the first connection block 66-1 is connected to the first power supply connection line 66, the first power supply connection line 66 with a main body portion extending in the first direction X and the first power supply line 71 with a main body portion extending in the second direction Y are connected to each other, so that the first power supply line 71 and the first power supply connection line 66 form a grid structure of a net-like connecting structure for transmitting the first power supply signal on the display substrate, which may not only effectively reduce a resistance of the first power supply line and reduce a voltage drop of the first power supply signal, but also effectively improve uniformity of the first power supply signal in the display substrate, effectively improve uniformity of display, and improve display quality.

In an exemplary implementation, an orthographic projection of the first power supply line 71 on the base substrate is at least partially overlapped with an orthographic projection of the second transistor T2 on the base substrate, and the first power supply line 71 having a constant voltage signal can effectively block interferences of other signals in the pixel drive circuit with the second transistor T2, thereby improving electrical performance and operating stability of the second transistor T2.

In an exemplary implementation, the data signal line 73 may be in a shape of a line in which a main body portion extends in the second direction Y, and the data signal line 73 is connected to the fourth connection electrode 54 through the twenty-second via V22. Since the fourth connection electrode 54 is connected with the first region of the fourth active layer through a via, it is achieved that a data signal can be written by the data signal line 73 to the first electrode of the fourth transistor T4.

In an exemplary implementation, the anode connection electrode 75 may be in a shape of a block (for example, a rectangle), and the anode connection electrode 75 is connected to the second connection electrode 52 through the twenty-first via V21. The anode connection electrode 75 is configured to be connected to an anode formed subsequently, and since the second connection electrode 52 is connected to the second region of the first active layer (also the second region of the sixth active layer) through a via, it can be realized that the pixel drive circuit outputs a drive current to a light emitting device.

In an exemplary implementation, the fourth conductive layer of at least one circuit unit may also include a second power supply line 72 and an initial connection line 74.

In an exemplary implementation, the second power supply line 72 may be in a shape of a line in which a main body portion extends in the second direction Y, and the second power supply line 72 is connected to the second connection block 67-1 through the twenty-fifth via V25. Since the second connection block 67-1 is connected to the second power supply connection line 67, the second power supply connection line 67 with a main body portion extending in the first direction X and the second power supply line 72 with a main body portion extending in the second direction Y are connected to each other, so that the second power supply line 72 and the second power supply connection line 67 form a grid structure of a net-like connecting structure for transmitting the second power supply signal on the display substrate, which can not only effectively reduce a resistance of the second power supply line and reduce a voltage drop of the second power supply signal, but also effectively improve uniformity of the second power supply signal in the display substrate, effectively improve display uniformity, and improve display quality.

In an exemplary implementation, the initial connection line 74 may be in a shape of a line in which a main body portion extends in the second direction Y, and the initial connection line 74 is connected to the initial connection block 65-1 through the twenty-sixth via V26. Since the initial connection block 65-1 is connected to the initial signal line 65, the initial signal line 65 with a main body portion extending in the first direction X and the initial connection line 74 with a main body portion extending in the second direction Y are connected to each other, so that the initial signal line 65 and the initial connection line 74 form a grid structure of a net-like connecting structure for transmitting an initial signal on the display substrate, which can not only effectively reduce a resistance of the initial signal line and reduce a voltage drop of the initial signal, but also effectively improve uniformity of the initial signal in the display substrate, effectively improve uniformity of display, and thus improve display quality.

In an exemplary implementation, the first power supply connection line 66 of the third conductive layer may be disposed in each unit row, the first power supply line 71 of the fourth conductive layer may be disposed in each unit column, and a plurality of first power supply lines 71 are connected, respectively, to a plurality of first power supply connection lines 66 to form a net-like structure for transmitting the first power supply signal.

In an exemplary implementation, the second power supply connection line 67 and the initial signal line 65 of the third conductive layer may be disposed in each unit row, the initial connection line 74 of the fourth conductive layer may be disposed in a unit column where the first circuit unit is located, and the second power supply line 72 of the fourth conductive layer may be disposed in a unit column where the second circuit unit is located and in a unit column where the third circuit unit is located. One initial connection line 74 and two second power supply connection lines 67 are periodically repeated in the first direction X. A plurality of initial signal lines 65 are respectively connected to a plurality of initial connection lines 74 to form a net-like structure for transmitting the initial signal, and a plurality of second power supply lines 72 are respectively connected to a plurality of second power supply connection lines 67 to form a net-like structure for transmitting the second power supply signal.

In an exemplary implementation, one second power supply connection line 67, one initial connection line 74, and one second power supply connection line 67 may be provided to be periodically repeated in the first direction X. In another exemplary implementation, one initial connection line 74, one second power supply connection line 67, and one initial connection line 74 may be provided to be periodically repeated in the first direction X.

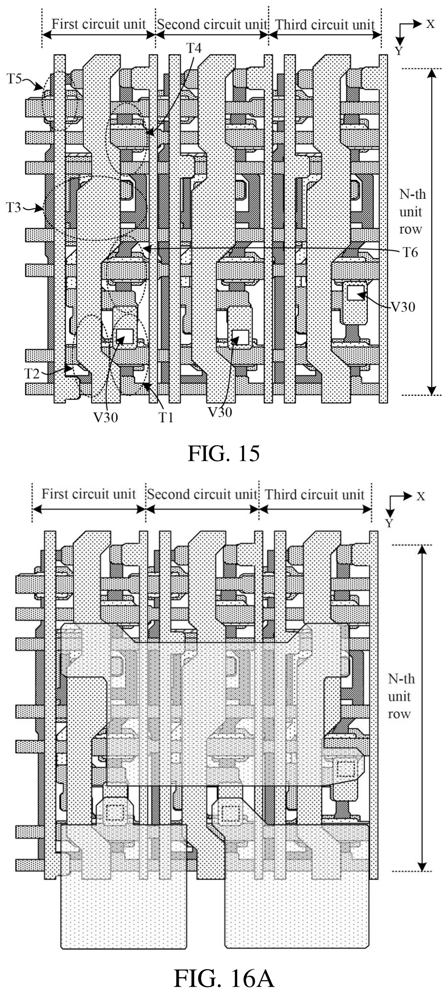

(9) In an exemplary implementation, a second planarization layer pattern is formed. In an exemplary implementation, forming the pattern of the second planarization layer may include: coating a second planarization thin film on the base substrate on which the aforementioned patterns are formed, patterning the second planarization thin film through a patterning process to form a second planarization layer covering the pattern of the fourth conductive layer, herein the second planarization layer is provided with a plurality of vias, as shown in FIG. 15.

In an exemplary implementation, a via in each circuit unit at least includes an anode via V30. An orthographic projection of the anode via V30 on the base substrate is within a range of an orthographic projection of the anode connection electrode 75 on the base substrate, the second planarization layer within the anode via V30 is removed to expose a surface of the anode connection electrode 75, and the anode via V30 is configured such that an anode formed subsequently is connected to the anode connection electrode 75 through the via V30.

So far, a drive circuit layer has been prepared on the base substrate. In a plane parallel to the display substrate, the drive circuit layer may include a plurality of circuit units. Each circuit unit may include a pixel drive circuit, and a first scan signal line, a second scan signal line, a first light emitting signal line, a second light emitting signal line, an initial signal line, a first power supply line, and a data signal line which are connected to the pixel drive circuit. In a plane perpendicular to the display substrate, the drive circuit layer may include a shielding conductive layer, a first insulation layer, a first conductive layer, a second insulation layer, a semiconductor layer, a third insulation layer, a second conductive layer, a fourth insulation layer, a third conductive layer, a fifth insulation layer, a first planarization layer, a fourth conductive layer and a second planarization layer which are disposed sequentially on the base substrate. The shielding conductive layer may include at least a first plate. The first conductive layer may include at least a second plate and bottom gate electrodes of a plurality of transistors. The semiconductor layer may include at least active layers of a plurality of transistors. The second conductive layer may include at least a third plate and top gate electrodes of a plurality of transistors. The third conductive layer may include at least a first scan signal line, a second scan signal line, a first light emitting signal line, a second light emitting signal line, an initial signal line, a first power supply connection line, a second power supply connection line, and a plurality of connection electrodes. The fourth conductive layer may include at least a first power supply line, a second power supply line, a data signal line, an initial connection line and an anode connection electrode.

In an exemplary implementation, the base substrate may be a flexible base substrate, or a rigid base substrate. The rigid base substrate may include, but is not limited to, one or more of glass and quartz. The flexible base substrate may be made of, but is not limited to, one or more of polyethylene terephthalate, ethylene terephthalate, polyether ether ketone, polystyrene, polycarbonate, polyarylate, polyarylester, polyimide, polyvinyl chloride, polyethylene, and textile fiber. In an exemplary implementation, the flexible base substrate may include a first flexible material layer, a first inorganic material layer, a semiconductor layer, a second flexible material layer and a second inorganic material layer stacked on the glass carrier plate. Materials of the first flexible material layer and the second flexible material layer may be Polyimide (PI), Polyethylene Terephthalate (PET), or a surface-treated polymer soft film, etc., and materials of the first inorganic material layer and the second inorganic material layer may be Silicon Nitride (SiNx), Silicon Oxide (SiOx), or the like, for improving water and oxygen resistance of the base substrate. The first inorganic material layer and the second inorganic material layer may also be referred to as barrier layers, and a material of the semiconductor layer may be amorphous silicon (a-si).

In an exemplary implementation, the first insulation layer, the second insulation layer, the third insulation layer, the fourth insulation layer, and the fifth insulation layer may be made of any one or more of Silicon Oxide (SiOx), Silicon Nitride (SiNx), and Silicon Oxynitride (SiON), and may be a single layer, a multilayer, or a composite layer. The shielding conductive layer, the first conductive layer, the second conductive layer, the third conductive layer, and the fourth conductive layer may be made of a metal material such as silver (Ag), copper (Cu), aluminum (Al), titanium (Ti), molybdenum (Mo), etc., or may be made of an alloy material composed of metals, such as an aluminum-neodymium alloy (AlNd) or a molybdenum-niobium alloy (MoNb) , etc., and may be of a single-layer structure or a multi-layer composite structure, such as Ti/Al/Ti or the like. The first planarization layer and the second planarization layer may be made of an organic material such as resin or polyimide.

In an exemplary implementation, after the drive circuit layer has been manufactured, a light emitting structure layer may be manufactured on the drive circuit layer.

In an exemplary implementation, manufacturing of the light emitting structure layer may include following operations.

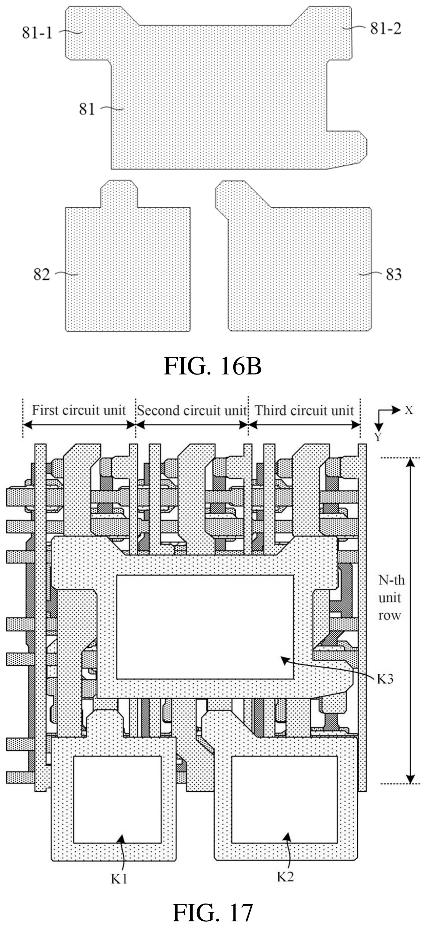

(11) A pattern of an anode conductive layer is formed. In an exemplary implementation, forming a pattern of an anode conductive layer may include: depositing an anode conductive thin film on the base substrate where the aforementioned patterns are formed, and patterning the anode conductive thin film through a patterning process to form the pattern of the anode conductive layer arranged on the planarization layer, as shown in FIG. 16A and FIG. 16B, and FIG. 16B is a planar schematic diagram of the anode conductive layer in FIG. 16A.

In an exemplary implementation, the pattern of the anode conductive layer may include at least a plurality of anodes, and the plurality of anodes may include at least a first anode 81 of a first light emitting unit, a second anode 82 of a second light emitting unit, and a third anode 83 of a third light emitting unit. The first anode 81, the second anode 82, and the third anode 83 may be respectively connected to an anode connection electrode 75 in a corresponding circuit unit through the anode via V30, thus realizing that the pixel drive circuit drives a light emitting device to emit light.

In an exemplary implementation, a plurality of light emitting units may constitute a plurality of light emitting rows and a plurality of light emitting columns. A light emitting row may include multiple light emitting units sequentially disposed in the first direction X, and a light emitting column may include multiple light emitting units sequentially disposed in the second direction Y.

In an exemplary implementation, in the first direction X, one light emitting row may include a first light emitting unit, an adjacent light emitting row may include a second light emitting unit and a third light emitting unit, and the three light emitting units may form a triangular pixel arrangement.

In an exemplary implementation, the first light emitting unit may include a first anode 81, the second light emitting unit may include a second anode 82, and the third light emitting unit may include a third anode 83. The first anode 81 in one light emitting row may be located between the second anode 82 and the third anode 83 in an adjacent light emitting row, and the three anodes form a Delta pixel arrangement.

In an exemplary implementation, shapes and areas of the first anode 81, the second anode 82 and the third anode 83 may be different.

In an exemplary implementation mode, the anode conductive layer may be of a single-layer structure, such as Indium Tin Oxide (ITO) or Indium Zinc Oxide (IZO), or may be of a multi-layer composite structure, such as ITO/Ag/ITO.

In an exemplary implementation, the first anode 81, the second anode 82, and the third anode 83 may each include an anode main body portion and an anode connection portion, the shape of the anode main body portion may be a rectangular shape, and the shape of the anode connection portion may be a block shape. A first end of the anode connection portion is connected to the anode main body portion, a second end of the anode connection portion extends in a direction away from the anode main body portion, and the anode connection portion is connected to an anode connection electrode 75 in a corresponding circuit unit through the anode via V30.

In an exemplary implementation, at least one anode may also include a compensation portion, and the shape of the compensation portion may be a block shape. A first end of the compensation portion is connected to the anode main body portion, and a second end of the compensation portion extends in a direction away from the anode main body portion. For example, the first anode 81 is provided with a first compensation portion 81-1 and a second compensation portion 81-2. An orthographic projection of the first compensation portion 81-1 on the base substrate is at least partially overlapped with an orthographic projection of the first power supply line 71 of the first circuit unit on the base substrate, an orthographic projection of the second compensation portion 81-2 on the base substrate is at least partially overlapped with an orthographic projection of the first power supply line 71 of the third circuit unit on the base substrate, and an orthographic projection of the anode main body portion of the first anode 81 on the base substrate is at least partially overlapped with an orthographic projection of the first power supply line 71 of the second circuit unit on the base substrate, so that the first anode 81 is evenly distributed with respect to first power supply lines 71, thereby improving light output quality of the light emitting device.

In an exemplary implementation, an orthographic projection of the first anode 81 on the base substrate is at least partially overlapped with orthographic projections of first power supply lines 71 of the first circuit unit, the second circuit unit and the third circuit unit on the base substrate, an orthographic projection of the second anode 82 on the base substrate is at least partially overlapped with an orthographic projection of the first power supply line 71 of the first circuit unit on the base substrate, and an orthographic projection of the third anode 83 on the base substrate is at least partially overlapped with an orthographic projection of the first power supply line 71 of the third circuit unit on the base substrate, so that anodes of three light emitting units are evenly distributed with respect to the first power supply line 71.

(12) A pattern of a pixel definition layer is formed. In an exemplary implementation, forming the pattern of the pixel definition layer may include: coating a pixel definition thin film on the base substrate on which the aforementioned patterns are formed, and patterning the pixel definition thin film through a patterning process to form a pattern of a pixel definition layer covering the anode conductive layer, herein the pattern of the pixel definition layer at least includes a plurality of pixel openings, as shown in FIG. 17.

In an exemplary implementation, the pattern of the pixel definition layer may at least include a plurality of pixel openings, and the plurality of pixel openings may at least include a first pixel opening K1 exposing the first anode 81, a second pixel opening K2 exposing the second anode 82, and a third pixel opening K3 exposing the third anode 83.

In an exemplary implementation, a subsequent manufacturing process may include: forming an organic light emitting layer using an evaporation or inkjet printing process, herein the organic light emitting layer is connected to an anode through a pixel opening, and forming a cathode on the organic light emitting layer, herein the cathode is connected to the organic light emitting layer. An encapsulation structure layer is formed, and the encapsulation structure layer may include a first encapsulation layer, a second encapsulation layer, and a third encapsulation layer that are stacked, herein the first encapsulation layer and the third encapsulation layer may be made of an inorganic material, the second encapsulation layer may be made of an organic material, and the second encapsulation layer is arranged between the first encapsulation layer and the third encapsulation layer, so that it may be ensured that external water vapor cannot enter a light emitting structure layer.

A large-size display substrate with high resolution has problems such as poor display, which reduces display quality. Through research, the inventors of the present application have found that problems such as poor display are caused to a certain extent by a slow compensation speed. Further research shows that since a scan signal line is disposed in a gate metal layer, a resistance of the scan signal line is large and a voltage drop of a scan signal is large, a slow compensation speed is caused when a data signal is written to a data signal line and threshold voltage compensation is synchronously performed, and thus a related poor display is caused.

As can be seen from the structure and manufacturing process of the display substrate described above, in an embodiment of the present disclosure, by disposing a first scan signal line and a second scan signal line in a first source-drain metal layer, resistances of the first scan signal line and the second scan signal line are effectively reduced and voltage drops of a first scan signal and a second scan signal are effectively reduced, and when a data signal is written by a data signal line to a fourth transistor T4 and threshold voltage compensation is synchronously performed, a compensation speed is effectively improved, thus improving display quality.

The pixel drive circuit according to the present exemplary embodiment can meet driving requirements by using six oxide transistors, which, compared with an existing pixel drive circuit structure with seven transistors, not only reduces the number of transistors, simplifies the structure of the pixel drive circuit structure, reduces the occupied area of the pixel drive circuit, and is beneficial to realizing high-resolution (PPI) display, but also ensures a yield of a large-size display substrate and reduces production cost.

In an embodiment of the present disclosure, the shielding conductive layer, the first conductive layer and the second conductive layer form a sandwich structure with a three-layer metal layout, and the first sub-capacitor and the second sub-capacitor in a parallel structure constitute the storage capacitor, which, on one hand, can effectively increase a capacitance value of the storage capacitor, and on the other hand, can reduce areas of plates while ensuring the capacitance value of the storage capacitor, thereby effectively reducing the occupied area.

In an embodiment of the present disclosure, by providing the first power supply connection line in which the main portion extends along the first direction X and the first power supply line in which the main portion extends along the second direction Y, and the first power supply connection line and the first power supply connection line being connected to each other, the first power supply line and the first power supply connection line form a net-like structure of a net shape for transmitting the first power supply signal in the display substrate, which can not only effectively reduce the resistance of the first power supply line and reduce the voltage drop of the first power supply signal, but also effectively improve the uniformity of the first power supply signal in the display substrate, effectively improve the display uniformity and improve the display quality.

In an embodiment of the present disclosure, the second power supply connection line with a main body portion extending in the first direction X and the second power supply line with a main body portion extending in the second direction Y are provided, and the second power supply line and the second power supply connection line are connected to each other, so that not only a structure of VSS in pixel is realized, but also the second power supply line and the second power supply connection line form a net-like structure of a net shape for transmitting a second power supply signal on the display substrate. Therefore, not only can a resistance of the second power supply line be effectively reduced, and a voltage drop of the second power supply signal be reduced, but also uniformity of the second power supply signal in the display substrate can be effectively improved, uniformity of display can be effectively improved, and thus display quality can be improved.

In an embodiment of the present disclosure, the initial signal line with a main body portion extending in the first direction X and the initial connection line with a main body portion extending in the second direction Y are provided, and the initial signal line and the initial connection line are connected to each other, so that the initial signal line and the initial connection line form a net-like structure of a net shape for transmitting an initial signal on the display substrate, which can not only effectively reduce a resistance of the initial signal line and reduce a voltage drop of the initial signal, but also effectively improve uniformity of the initial signal in the display substrate, and effectively improve uniformity of display, thus improving display quality.

In an embodiment of the present disclosure, by providing the first anode, the second anode, and the third anode to be evenly distributed with respect to the first power supply line, light output quality of the light emitting device is improved.

The manufacturing process in the present disclosure may be compatible well with an existing Manufacturing process, is simple in process implementation, is easy to implement, and has a high production efficiency, a low production cost, and a high yield.

The aforementioned structure shown in the present disclosure and the manufacturing process thereof are merely exemplary description. In an exemplary implementation mode, corresponding structures may be changed and patterning processes may be added or reduced according to actual needs, which is not limited here in the present disclosure.

In an exemplary implementation mode, the display substrate according to the present disclosure may be applied to a display apparatus with a pixel drive circuit, such as an OLED, quantum dot display (QLED), light emitting diode display (Micro LED or Mini LED), or Quantum Dot Light Emitting Diode display (QDLED), which is not limited here in the present disclosure.

The present disclosure also provides a preparation method for a display substrate, for preparing the display substrate according to the foregoing embodiments. In an exemplary implementation, the preparation method may include: forming a drive circuit layer on a base substrate, herein the drive circuit layer includes a plurality of circuit units, at least one scan signal line extending in a first direction, and at least one data signal line extending in a second direction, and the first direction is intersected with the second direction. At least one circuit unit includes a pixel drive circuit, the pixel drive circuit includes at least a plurality of oxide transistors, and at least one oxide transistor is connected to the scan signal line and the data signal line, respectively. In a direction perpendicular to the base substrate, the drive circuit layer includes at least a first source-drain metal layer and a second source-drain metal layer that are sequentially disposed along a direction away from the base substrate. The first source-drain metal layer includes at least the scan signal line, and the second source-drain metal layer includes at least the data signal line.

A display apparatus which includes the aforementioned display substrate is also provided in the present disclosure. The display apparatus may be any product or component with a display function, such as a mobile phone, a tablet computer, a television, a display, a laptop computer, a digital photo frame, and a navigator, which is not limited in the embodiments of the present invention.

Although implementations disclosed in the present disclosure are described as above, the described contents are only implementations which are used for facilitating understanding of the present disclosure, but are not intended to limit the present invention. Any skilled person in the art to which the present disclosure pertains may make any modification and variation in a form and details of implementation without departing from the essence and scope of the present disclosure. However, the patent protection scope of the present invention should be subject to the scope defined in the appended claims.

## Claims

1. A display substrate comprising a drive circuit layer disposed on a base substrate, wherein the drive circuit layer comprises a plurality of circuit units, at least one scan signal line extending in a first direction, and at least one data signal line extending in a second direction, and the first direction is intersected with the second direction; at least one circuit unit comprises a pixel drive circuit, the pixel drive circuit comprises at least a plurality of oxide transistors, and at least one oxide transistor is connected to the scan signal line and the data signal line, respectively; in a direction perpendicular to the base substrate, the drive circuit layer comprises at least a first source-drain metal layer and a second source-drain metal layer that are sequentially disposed along a direction away from the base substrate, the first source-drain metal layer comprises at least the scan signal line, and the second source-drain metal layer comprises at least the data signal line.

2. The display substrate of claim 1, wherein the drive circuit layer further comprises a first conductive layer and a second conductive layer that are sequentially disposed along the direction away from the base substrate, and the first source-drain metal layer is disposed on a side of the second conductive layer away from the base substrate; at least one oxide transistor comprises at least a bottom gate electrode disposed in the first conductive layer and a top gate electrode disposed in the second conductive layer, and the scan signal line is connected to the bottom gate electrode and the top gate electrode respectively through a via.

3. The display substrate of claim 1, wherein the pixel drive circuit further comprises a storage capacitor, the storage capacitor comprises a first sub-capacitor and a second sub-capacitor, the first sub-capacitor comprises a first plate and a second plate, an orthographic projection of the first plate on the base substrate is at least partially overlapped with an orthographic projection of the second plate on the base substrate, the second sub-capacitor comprises the second plate and a third plate, the orthographic projection of the second plate on the base substrate is at least partially overlapped with an orthographic projection of the third plate on the base substrate, and the first plate is connected to the third plate.

4. The display substrate of claim 3, wherein the drive circuit layer further comprises a shielding conductive layer, a first conductive layer, and a second conductive layer that are sequentially disposed along the direction away from the base substrate, the first source-drain metal layer is disposed on a side of the second conductive layer away from the base substrate, the first plate is disposed in the shielding conductive layer, the second plate is disposed in the first conductive layer, the third plate is disposed in the second conductive layer, and the third plate is connected to the first plate through a connection electrode.

5. The display substrate of claim 4, wherein the connection electrode is disposed in the first source-drain metal layer, a first terminal of the connection electrode is connected to the first plate through a via, and a second terminal of the connection electrode is connected to the third plate through a via.

6. The display substrate of claim 1, wherein the plurality of oxide transistors comprise a first transistor, a second transistor, a third transistor, a fourth transistor, a fifth transistor, and a sixth transistor; a first electrode of the first transistor is connected to an initial signal line, a second electrode of the first transistor is connected to a second electrode of the sixth transistor and a second plate of a storage capacitor respectively, a first electrode of the second transistor is connected to a gate electrode of the third transistor and a first plate of the storage capacitor respectively, a second electrode of the second transistor is connected to a first electrode of the third transistor and a second electrode of the fifth transistor respectively, a second electrode of the third transistor is connected to a second electrode of the fourth transistor and a first electrode of the sixth transistor respectively, a first electrode of the fourth transistor is connected to the data signal line, and a first electrode of the fifth transistor is connected to a first power supply line; the fourth transistor and the fifth transistor are disposed on a side of the third transistor in the second direction, and the first transistor, the second transistor, and the sixth transistor are disposed on another side of the third transistor in the second direction.

7. The display substrate of claim 6, wherein the first transistor comprises at least a first bottom gate electrode and a first top gate electrode, the second transistor comprises at least a second bottom gate electrode and a second top gate electrode, the first bottom gate electrode and the second bottom gate electrode are of an interconnected integral structure, and the first top gate electrode and the second top gate electrode are of an interconnected integral structure.

8. The display substrate of any one of claims 1 to 7, wherein the drive circuit layer further comprises at least one first power supply connection line extending in the first direction and at least one first power supply line extending in the second direction, and the first power supply line is connected to the first power supply connection line to form a net-like structure for transmitting a first power supply signal.

9. The display substrate of claim 8, wherein the display substrate further comprises a light emitting structure layer disposed on a side of the drive circuit layer away from the base substrate, the light emitting structure layer comprises a plurality of light emitting units, at least one light emitting unit comprises an anode, and at least one anode is uniformly distributed with respect to the first power supply line.

10. The display substrate of claim 9, wherein the plurality of circuit units comprise a first circuit unit, a second circuit unit, and a third circuit unit that are sequentially disposed along the first direction; at least one anode comprises an anode main body portion, a first compensation portion, and a second compensation portion, an orthographic projection of the first compensation portion on the base substrate is at least partially overlapped with an orthographic projection of a first power supply line of the first circuit unit on the base substrate, an orthographic projection of the anode main body portion on the base substrate is at least partially overlapped with an orthographic projection of a first power supply line of the second circuit unit on the base substrate, and an orthographic projection of the second compensation portion on the base substrate is at least partially overlapped with an orthographic projection of a first power supply line of the third circuit unit on the base substrate.

11. The display substrate of claim 10, wherein the plurality of light emitting units comprise a first light emitting unit, a second light emitting unit, and a third light emitting unit that are arranged in a triangle; an orthographic projection of an anode of the first light emitting unit on the base substrate is at least partially overlapped with orthographic projections of first power supply lines of the first circuit unit, the second circuit unit and the third circuit unit on the base substrate, an orthographic projection of an anode of the second light emitting unit on the base substrate is at least partially overlapped with the orthographic projection of the first power supply line of the second circuit unit on the base substrate, and an orthographic projection of an anode of the third light emitting unit on the base substrate is at least partially overlapped with the orthographic projection of the first power supply line of the third circuit unit on the base substrate.

12. The display substrate of any one of claims 1 to 7, wherein the drive circuit layer further comprises at least one second power supply connection line extending in the first direction and at least one second power supply line extending in the second direction, and the second power supply line is connected to the second power supply connection line to form a net-like structure for transmitting a second power supply signal.

13. The display substrate of any one of claims 1 to 7, wherein the drive circuit layer further comprises at least one initial signal line extending in the first direction and at least one initial connection line extending in the second direction, and the initial signal line is connected to the initial connection line to form a net-like structure for transmitting an initial signal.

14. A display apparatus, comprising the display substrate according to any one of claims 1 to 13.

15. A preparation method of a display substrate, comprising:
forming a drive circuit layer on a base substrate, wherein the drive circuit layer comprises a plurality of circuit units, at least one scan signal line extending in a first direction, and at least one data signal line extending in a second direction, and the first direction is intersected with the second direction; at least one circuit unit comprises a pixel drive circuit, the pixel drive circuit comprises at least a plurality of oxide transistors, at least one oxide transistor is connected to the scan signal line and the data signal line respectively; in a direction perpendicular to the base substrate, the drive circuit layer comprises at least a first source-drain metal layer and a second source-drain metal layer that are sequentially disposed along a direction away from the base substrate, the first source-drain metal layer comprises at least the scan signal line, and the second source-drain metal layer comprises at least the data signal line.
